# EUROPEAN PATENT APPLICATION

(11) **EP 4 518 603 A2**
(43) Date of publication of application: **05.03.2025**
(21) Application number: 24191732.7
(22) Date of filing: 30.07.2024
(51) Int. Cl.: H10B 12/00, H01L 23/522, H10D 1/68

(54) **SEMICONDUCTOR DEVICE**

(30) Priority: 01.09.2023 KR 20230116109
(71) Applicant: Samsung Electronics Co., Ltd, Suwon-si, Gyeonggi-do 16677 (KR)
(72) Inventor: KIM, Seungmuk, 16677 Suwon-si (KR); LEE, Kiseok, 16677 Suwon-si (KR); KIM, Keunnam, 16677 Suwon-si (KR); LEE, Hongjun, 16677 Suwon-si (KR)
(74) Representative: Marks & Clerk LLP

(57) **Abstract**

A semiconductor device includes a first gate structure in a cell region of a substrate, where the substrate includes a peripheral circuit region, a bit line structure on the cell region of the substrate, a cell capacitor structure on the bit line structure, a decoupling capacitor structure on the peripheral circuit region of the substrate, and a second gate structure on the decoupling capacitor structure.

## Description

### TECHNICAL FIELD

Example embodiments of the present disclosure relate to a semiconductor device. More particularly, example embodiments of the present disclosure relate to a DRAM device.

### BACKGROUND

In a DRAM device, cell capacitors may be formed in a cell region, and decoupling capacitors and peripheral circuit transistors may be formed in a peripheral circuit region. As the DRAM is highly integrated, a space for forming both the decoupling capacitors and the peripheral circuit transistors may not be sufficient.

### SUMMARY

Example embodiments provide a semiconductor device having improved electrical characteristics.

According to example embodiments of the present disclosure, there is a semiconductor device. The semiconductor device may include a first gate structure in a cell region of a substrate, where the substrate includes a peripheral circuit region, a bit line structure on the cell region of the substrate, a cell capacitor structure on the bit line structure, a decoupling capacitor structure on the peripheral circuit region of the substrate, and a second gate structure on the decoupling capacitor structure.

According to example embodiments of the present disclosure, there is a semiconductor device. The semiconductor device may include a first gate structure in a cell region of a first substrate, where the first substrate includes a peripheral circuit region, a bit line structure on the cell region of the first substrate, a cell capacitor structure on the bit line structure, a decoupling capacitor structure at least partially in the peripheral circuit region of the first substrate, and a second gate structure on the peripheral circuit region of the first substrate, where the second gate structure is a first distance from an upper surface of the first substrate, where the cell capacitor structure is a second distance from the upper surface of the first substrate, and where the first distance is greater than the second distance.

According to example embodiments of the present disclosure, there is a semiconductor device. The semiconductor device may include a first substrate including a first cell region and a first peripheral circuit region, a first gate structure in the first cell region of the first substrate, a bit line structure on the first cell region of the first substrate, a cell capacitor structure on the bit line structure, a decoupling capacitor structure on the first peripheral circuit region of the first substrate, a second substrate on the cell capacitor structure and the decoupling capacitor structure, where the second substrate includes a second cell region and a second peripheral circuit region that correspond to the first cell region of the first substrate and the first peripheral circuit region of the first substrate, respectively, a second gate structure on the second cell region of the second substrate, a third gate structure on the second peripheral circuit region of the second substrate, and through vias that extend into the second substrate, where ones of the through vias are electrically connected to the cell capacitor structure and the decoupling capacitor structure.

The semiconductor device in accordance with example embodiments may have a sufficient space for peripheral circuit transistors and decoupling capacitors, and thus may have enhanced electric characteristics.

At least some of the above and other features of the invention are set out in the claims.

### BRIEF DESCRIPTION OF THE DRAWINGS

FIG. 1 is a cross-sectional view illustrating a semiconductor device in accordance with example embodiments.
FIGS. 2, 3, 4, 5, 6, 7, and 8 are cross-sectional views illustrating semiconductor devices in accordance with example embodiments.
FIGS. 9, 10, 11, 12, 13, and 14 are cross-sectional views illustrating semiconductor devices in accordance with example embodiments.
FIGS. 15, 16, 17, 18, 19, 20, 21, and 22 are cross-sectional views illustrating semiconductor devices in accordance with example embodiments.
FIGS. 23, 24, 25, 26, 27, 28, 29, 30, 31, 32, 33, 34, 35, 36, 37, 38, 39, 40, 41, 42, 43, 44, 45, 46, 47, 48, 49, 50, 51, 52, 53, 54, 55, 56, 57, 58, 59, 60, 61, 62, 63, 64, and 65 are plan views and cross-sectional views illustrating a method of manufacturing a semiconductor device according to example embodiments.

### DETAILED DESCRIPTION

The above and other aspects and features of a decoupling capacitor structure and a method of forming the same, and a semiconductor device including the decoupling capacitor structure and a method of manufacturing the same in accordance with example embodiments will become readily understood from detail descriptions that follow, with reference to the accompanying drawings. It will be understood that, although the terms "first," "second," and/or "third" may be used herein to describe various elements, components, regions, layers and/or sections, these elements, components, regions, layers and/or sections should not be limited by these terms. These terms are only used to distinguish one element, component, region, layer or section from another region, layer or section. Thus, a first element, component, region, layer or section discussed below could be termed a second or third element, component, region, layer or section without departing from the teachings of present disclosure.

To clarify the present disclosure, parts that are not connected with the description will be omitted, and the same elements or equivalents are referred to by the same reference numerals throughout the specification. Further, since sizes and thicknesses of constituent members shown in the accompanying drawings are arbitrarily given for better understanding and ease of description, the present disclosure is not limited to the illustrated sizes and thicknesses. In the drawings, the thickness of layers, films, panels, regions, etc., are exaggerated for clarity. In the drawings, for better understanding and ease of description, thicknesses of some layers and areas are excessively displayed.

It will be understood that when an element such as a layer, film, region, or substrate is referred to as being "on" another element, it can be directly on the other element or intervening elements may also be present. In contrast, when an element is referred to as being "directly on" another element, there are no intervening elements present. Further, spatially relative terms, such as "beneath," "below," "lower," "above," "upper," and the like, may be used herein for ease of description to describe one element's or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. Thus, the term "below" can encompass both an orientation of above and below. The device may be otherwise oriented (rotated 90 degrees or at other orientations), and the spatially relative descriptors used herein may be interpreted accordingly.

In addition, unless explicitly described to the contrary, the word "comprises", and variations such as "comprises" or "comprising", will be understood to imply the inclusion of stated elements but not the exclusion of any other elements. As used herein, the phrase "at least one of A, B, and C" refers to a logical (A OR B OR C) using a non-exclusive logical OR, and should not be construed to mean "at least one of A, at least one of B and at least one of C." As used herein, the singular forms "a," "an" and "the" are intended to include the plural forms as well, unless the context clearly indicates otherwise. It will be further understood that the terms "comprises," "comprising," "includes" and/or "including," when used herein, specify the presence of stated features, steps, operations, elements and/or components, but do not preclude the presence or addition of one or more other features, steps, operations, elements, components and/or groups thereof. The term "and/or" includes any and all combinations of one or more of the associated listed items. The term "connected" may be used herein to refer to a physical and/or electrical connection and may refer to a direct or indirect physical and/or electrical connection. Components or layers described with reference to "overlap" in a particular direction may be at least partially obstructed by one another when viewed along a line extending in the particular direction or in a plane perpendicular to the particular direction.

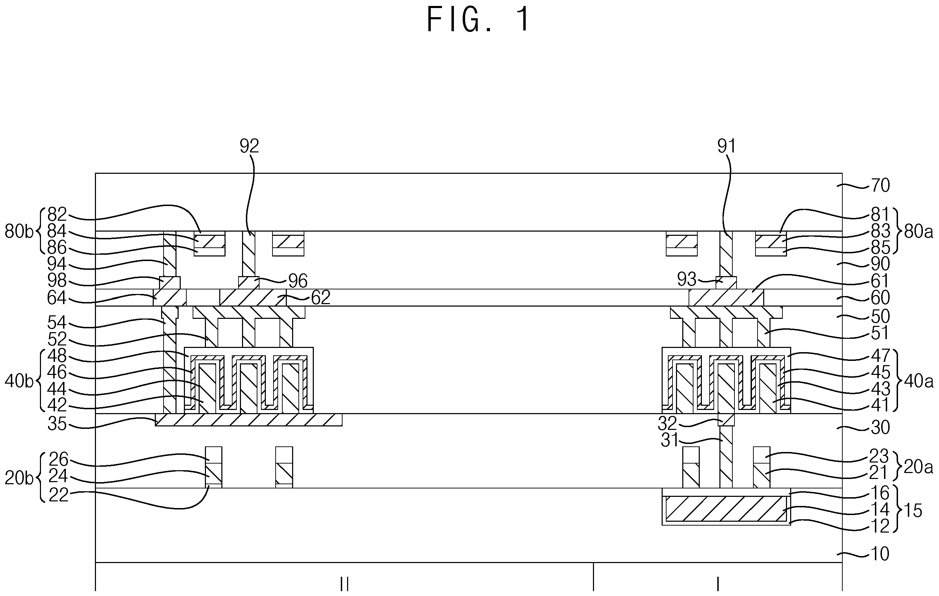

FIG. 1 is a cross-sectional view illustrating a semiconductor device in accordance with example embodiments.

Referring to FIG. 1, the semiconductor device may include a first substrate 10, a first gate structure 15 in the first substrate 10, a bit line structure 20a on the first substrate 10, a cell capacitor structure 40a, a first decoupling capacitor structure 40b, a second substrate 70, and third and fourth gate structures 80a and 80b under the second substrate 70. In the following description, a "horizontal" direction may be a direction parallel to the plane of the substrate 10, and a "vertical" direction may be a direction perpendicular to the plane of the substrate 10.

The semiconductor device may further include a second gate structure 20b, a first contact plug 31, a landing pad 32, a conductive pad 35, first to third capacitor connection structures 51, 52 and 54, first to third bonding patterns 61, 62 and 64, second to fourth contact plugs 91, 92 and 94, first to third wirings 93, 96 and 98, first to third insulating interlayers 30, 50 and 90, and a bonding layer 60.

Each of the first and second substrates 10 and 70 may include first and second regions I and II. In example embodiments, the first region I of each of the first and second substrates 10 and 70 may be a cell region in which memory cells are formed, and the second region II of each of the first and second substrates 10 and 70 may be a peripheral circuit region in which peripheral circuit patterns for driving the memory cells are formed.

Hereinafter, in some cases, the first and second regions I and II may be defined not only as being inside of each of the first and second substrates 10 and 70, but also in a space overlapping the inside of each of the first and second substrates 10 and 70 in a vertical direction substantially perpendicular to an upper surface of the first substrate 10 or to a lower surface of the second substrate 70.

Each of the first and second substrates 10 and 70 may include a semiconductor material, e.g., silicon, germanium, silicon-germanium, etc., or a III-V group compound semiconductor, e.g., GaP, GaAs, GaSb, etc. In example embodiments, each of the first and second substrates 10 and 70 may be a silicon-on-insulator (SOI) substrate or a germanium-on-insulator (GOI) substrate.

In example embodiments, the first gate structure 15 may be buried in the first region I of the first substrate 10, and a plurality of first gate structures 15 may be spaced apart from each other in a horizontal direction substantially parallel to the upper surface of the first substrate 10. Alternatively, the first gate structure 15 may be formed on the first substrate 10. Each of the first gate structures 15 may operate as a word line of the semiconductor device.

The first gate structure 15 may include a first gate electrode 14, a first gate insulation pattern 12 on a lower surface and a sidewall of the first gate electrode 14, and a first gate mask 16 on the first gate insulation pattern 12 and the first gate electrode 14.

In example embodiments, a plurality of bit line structures 20a may be spaced apart from each other in the horizontal direction on the first region I of the first substrate 10, and each of the bit line structures 20a may include a conductive structure 21 and an insulation structure 23 sequentially stacked in the vertical direction.

The second gate structure 20b may be formed on the second region II of the first substrate 10, and may include a second gate insulation pattern 22, a second gate electrode 24 and a second gate mask 26 sequentially stacked in the vertical direction. In example embodiments, the second gate structure 20b may be disposed at a height substantially the same as the bit line structure 20a from the upper surface of the first substrate 10. That is, the bit line structure 20a and the second gate structure 20b may extend from the first substrate 10 by substantially the same distance.

The second gate insulation pattern 22 may include an oxide, e.g., silicon oxide, each of the conductive structure 21 and the second gate electrode 24 may include, for example, doped polysilicon, a metal, a metal silicon nitride, a metal silicide, etc., and each of the insulation structure 23 and the second gate mask 26 may include an insulating nitride, e.g., silicon nitride.

The first insulating interlayer 30 may be formed on the first substrate 10, and may cover or overlap the bit line structure 20a and the second gate structure 20b.

The first contact plug 31 and the landing pad 32 may extend through the first insulating interlayer 30 on the first region I of the first substrate 10, and may be stacked in the vertical direction on the upper surface of the first substrate 10. A plurality of first contact plugs 31 may be spaced apart from each other in the horizontal direction, and a plurality of landing pads 32 may be spaced apart from each other in the horizontal direction.

The conductive pad 35 may extend through an upper portion of the first insulating interlayer 30 on the second region II of the first substrate 10. In example embodiments, the conductive pad 35 may be disposed at a height substantially the same as the landing pad 32, and may include substantially the same material. In example embodiments, a plurality of conductive pads 35 may be spaced apart from each other in the horizontal direction.

Each of the first contact plug 31, the landing pad 32 and the conductive pad 35 may include, for example, doped polysilicon, a metal, a metal nitride, a metal silicide, etc.

The cell capacitor structure 40a may be formed on the first insulating interlayer 30 on the first region I of the first substrate 10, and may contact an upper surface of the landing pad 32. The cell capacitor structure 40a may include a first capacitor electrode 41, a first dielectric pattern 43, a second capacitor electrode 45 and a third capacitor electrode 47. In example embodiments, the cell capacitor structure 40a may include a plurality of first capacitor electrodes 41, which are spaced apart from each other in the horizontal direction and contact the upper surfaces of the landing pads 32, respectively. Each of the first capacitor electrodes 41 may have a shape of a pillar extending in the vertical direction or a hollow cylinder, and the first capacitor electrodes 41 may be arranged in a honeycomb pattern or a lattice pattern in a plan view.

The first dielectric pattern 43, the second capacitor electrode 45 and the third capacitor electrode 47 may be sequentially stacked on surfaces of the first capacitor electrodes 41 (e.g., upper and side surfaces of the first capacitor electrodes 41) and an upper surface of the first insulating interlayer 30.

In example embodiments, a plurality of cell capacitor structures 40a may be spaced apart from each other in the horizontal direction on the first region I of the first substrate 10.

The first decoupling capacitor structure 40b may be formed on the conductive pad 35 on the second region II of the first substrate 10, and may include a fourth capacitor electrode 42, a second dielectric pattern 44, a fifth capacitor electrode 46 and a sixth capacitor electrode 48. In example embodiments, the first decoupling capacitor structures 40b may include a plurality of fourth capacitor electrodes 42, which are spaced apart from each other in the horizontal direction on the second region II of the first substrate 10. Each of the fourth capacitor electrodes 42 may have a shape of a pillar extending in the vertical direction or a hollow cylinder, and the fourth capacitor electrodes 42 may be arranged in a honeycomb pattern or a lattice pattern in a plan view.

The second dielectric pattern 44, the fifth capacitor electrode 46 and the sixth capacitor electrode 48 may be sequentially stacked on surfaces of the fourth capacitor electrodes 42 and an upper surface of the conductive pad 35.

In example embodiments, a plurality of first decoupling capacitor structures 40b may be spaced apart from each other in the horizontal direction on the second region II of the first substrate 10, and may contact the conductive pads 35, respectively. The first decoupling capacitor structure 40b may also be referred to as a power capacitor structure.

Each of the first, second, fourth and fifth capacitor electrodes 41, 45, 42 and 46 may include a conductive material, e.g., a metal, a metal nitride, etc., and each of the first and second dielectric patterns 43 and 44 may include a high-k dielectric material such as a metal oxide, e.g., hafnium oxide, zirconium oxide, etc. Each of the third and sixth capacitor electrodes 47 and 48 may include, for example, doped silicon-germanium.

The first capacitor connection structure 51 may be formed on the cell capacitor structure 40a, and may contact an upper surface of the third capacitor electrode 47 to be electrically connected thereto, the second capacitor connection structure 52 may be formed on the first decoupling capacitor structure 40b, and may contact an upper surface of the sixth capacitor electrode 48 to be electrically connected thereto, and the third capacitor connection structure 54 may contact an upper surface of the conductive pad 35 to be electrically connected thereto.

In the drawings, each of the first and second capacitor connection structures 51 and 52 includes an upper (i.e. further from the substrate) portion having a shape of a plane and vertical portions extending in the vertical direction (e.g. towards the substrate), and the third capacitor connection structure 54 includes a lower portion having a relatively small width and an upper portion having a relatively large width. However, the present disclosure may not be limited thereto.

The second insulating interlayer 50 may be formed on the first insulating interlayer 30, and may cover or overlap the cell capacitor structure 40a, the first decoupling capacitor structure 40b, and sidewalls of the first to third capacitor connection structures 51, 52 and 54.

The bonding layer 60 may be formed on the second insulating interlayer 50 and the first to third capacitor connection structures 51, 52 and 54, and the first to third bonding patterns 61, 62 and 64 may extend through the bonding layer 60 to contact upper surfaces of the first to third capacitor connection structures 51, 52 and 54, respectively. The bonding layer 60 may include an insulating material, e.g., silicon carbonitride (SiCN) or silicon oxide, and the first to third bonding patterns 61, 62 and 64 may include a metal, e.g., copper.

The third insulating interlayer 90 may be formed on the bonding layer 60 and the first to third bonding patterns 61, 62 and 64, and may cover or overlap the third and fourth gate structures 80a and 80b, the second to fourth contact plugs 91, 92 and 94, and sidewalls of the first to third wirings 93, 96 and 98.

The third gate structure 80a may include a third gate insulation pattern 81, a third gate electrode 83 and a third gate mask 85 sequentially stacked in the vertical direction from a lower surface of the first region I of the second substrate 70. The fourth gate structure 80b may include a fourth gate insulation pattern 82, a fourth gate electrode 84 and a fourth gate mask 86 sequentially stacked in the vertical direction from a lower surface of the second region II of the second substrate 70.

The third gate structure 80a and a first source/drain region at a lower portion of the first region I of the second substrate 70 adjacent to the third gate structure 80a may form a first peripheral circuit transistor, e.g., a core transistor. The fourth gate structure 80b and a second source/drain region at a lower portion of the second region II of the second substrate 70 adjacent to the fourth gate structure 80b may form a second peripheral circuit transistor, e.g., a peri transistor.

The second contact plug 91 and the first wiring 93 may be sequentially stacked in the vertical direction from the lower surface of the first region I of the second substrate 70 to contact an upper surface of the first bonding pattern 61. The third contact plug 92 and the second wiring 96 may be sequentially stacked in the vertical direction from the lower surface of the second region II of the second substrate 70 to contact an upper surface of the second bonding pattern 62. The fourth contact plug 94 and the third wiring 98 may be sequentially stacked in the vertical direction from the lower surface of the second region II of the second substrate 70 to contact an upper surface of the third bonding pattern 64.

In example embodiments, the second contact plug 91 may contact the first source/drain region of the first peripheral circuit transistor to be electrically connected thereto, and each of the third and fourth contact plugs 92 and 94 may contact the second source/drain region of the second peripheral circuit transistor to be electrically connected thereto.

Each of the first, third and fourth gate insulation patterns 12, 81 and 82 may include an oxide, e.g., silicon oxide. Each of the first, third and fourth gate electrodes 14, 83 and 84 may include, for example, a metal, a metal nitride, a metal silicide, etc. Each of the first, third and fourth gate masks 16, 85 and 86 may include an insulating nitride, e.g., silicon nitride.

Each of the first and second capacitor connection structures 51 and 52, the second to fourth contact plugs 91, 92 and 94, and the first to third wirings 93, 96 and 98 may include, for example, a metal, a metal nitride, a metal silicide, etc., and each of the first to third insulating interlayers 30, 50 and 90 may include an oxide, e.g., silicon oxide, an insulating nitride, e.g., silicon nitride, or a low-k dielectric material.

The semiconductor device may include the first and second substrates 10 and 70 sequentially stacked in the vertical direction. Transistors, word lines, bit lines and wiring structures may be disposed on the first substrate 10 and under the second substrate 70 so as to be electrically connected thereto through the first to third bonding patterns 61, 62 and 64 in the bonding layer 60.

In example embodiments, the first and second peripheral circuit transistors may be disposed under the first and second regions I and II, respectively, of the second substrate 70. Thus, when compared to an embodiment in which the first and second peripheral circuit transistors are disposed on the second region II of the first substrate 10, a sufficient space may be provided on the second region II of the first substrate 10, and an additional space may be provided under the second substrate 70.

Accordingly, a space for forming, e.g., additional first decoupling capacitor structures 40b, may be provided on the second region II of the first substrate 10, and a space for forming additional first and second peripheral circuit transistors may be provided under the first and second regions I and II, respectively, of the second substrate 70.

As a result, the semiconductor device may have additional space for forming, e.g., transistors, capacitors, etc., so as to have enhanced electrical characteristics.

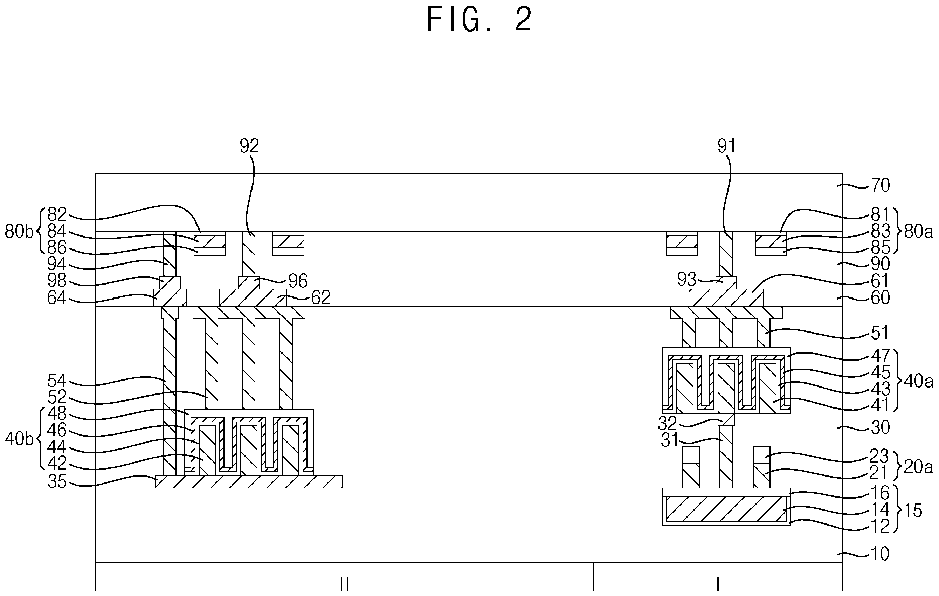

FIGS. 2 to 8 are cross-sectional views illustrating semiconductor devices in accordance with example embodiments. These semiconductor devices may be substantially the same as or similar to that of FIG. 1, and thus repeated explanations are omitted herein.

Referring to FIG. 2, the second gate structure 20b may not be disposed on the second region II of the first substrate 10 (e.g. it may be absent), and the conductive pad 35 under the first decoupling capacitor structure 40b may contact an upper surface of the second region II of the first substrate 10.

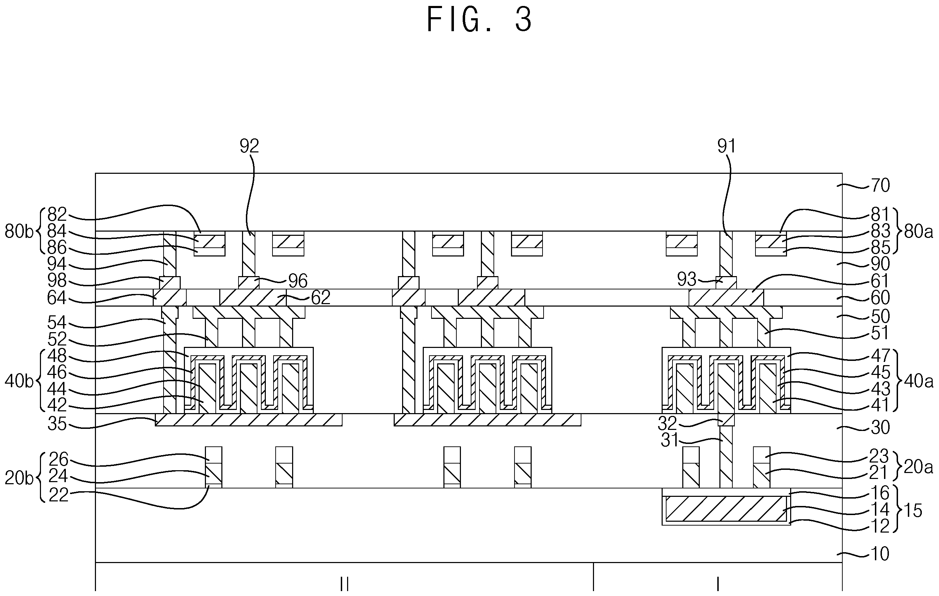

Referring to FIG. 3, as the first and second peripheral circuit transistors are not disposed on the second region II of the first substrate 10, additional first decoupling capacitor structures 40b may be disposed in a space on the second region II of the first substrate 10.

The second and third capacitor connection structures 52 and 54, the second and third bonding patterns 62 and 64, the second and third wirings 96 and 98, and the third and fourth contact plugs 92 and 94 may be additionally formed to be electrically connected to the additional first decoupling capacitor structures 40b.

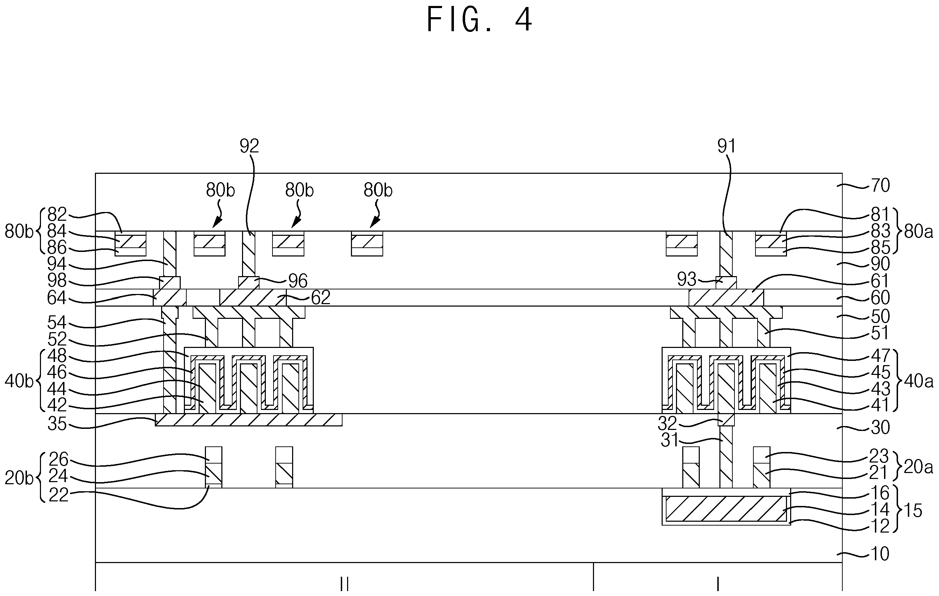

Referring to FIG. 4, as an additional second substrate 70 may be disposed over the first substrate 10, an additional second peripheral circuit transistor including the fourth gate structure 80b may be disposed in a space under the first and second regions I and II of the second substrate 70, particularly, in a space under the second region II of the second substrate 70.

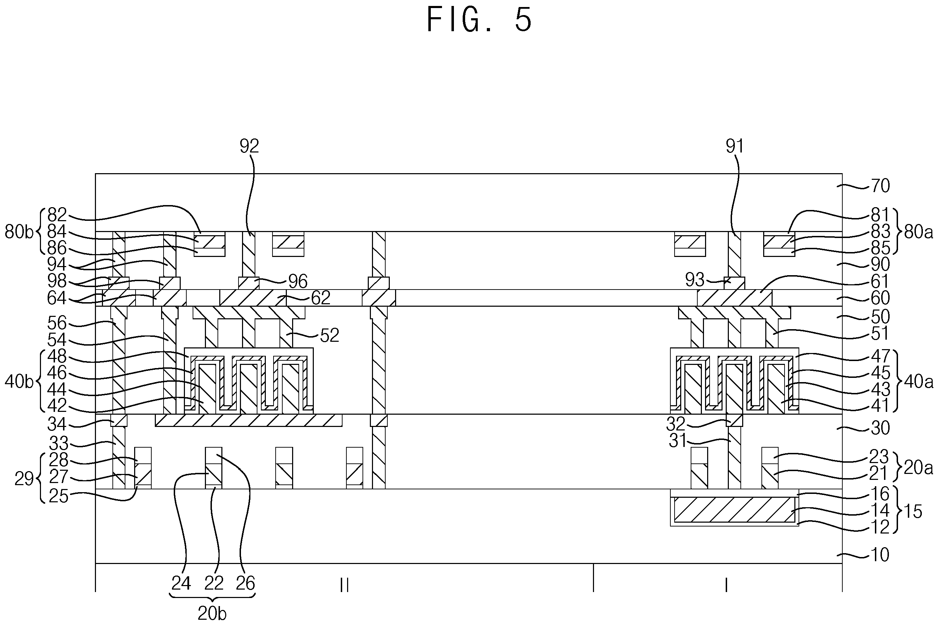

Referring to FIG. 5, as the first and second peripheral circuit transistors are not (in this embodiment) disposed on the second region II of the first substrate 10 (e.g. they may be absent), a third peripheral circuit transistor may be additionally disposed in a space on the second region II of the first substrate 10.

In example embodiments, the third peripheral circuit transistor may be a different type of transistor from the first and second peripheral circuit transistors. The third peripheral circuit transistor may include a fifth gate structure 29 on the second region II of the first substrate 10 and a third source/drain region at an upper portion of the second region II of the first substrate 10. The fifth gate structure 29 may include a fifth gate insulation pattern 25, a fifth gate electrode 27 and a fifth gate mask 28 that are sequentially stacked.

A fifth contact plug 33 and a fourth wiring 34 electrically connected thereto the third peripheral circuit transistor may be formed in the first insulating interlayer 30, and a sixth contact plug 56 extending through the second insulating interlayer 50 to contact the third bonding pattern 64 may be formed on the fourth wiring 34.

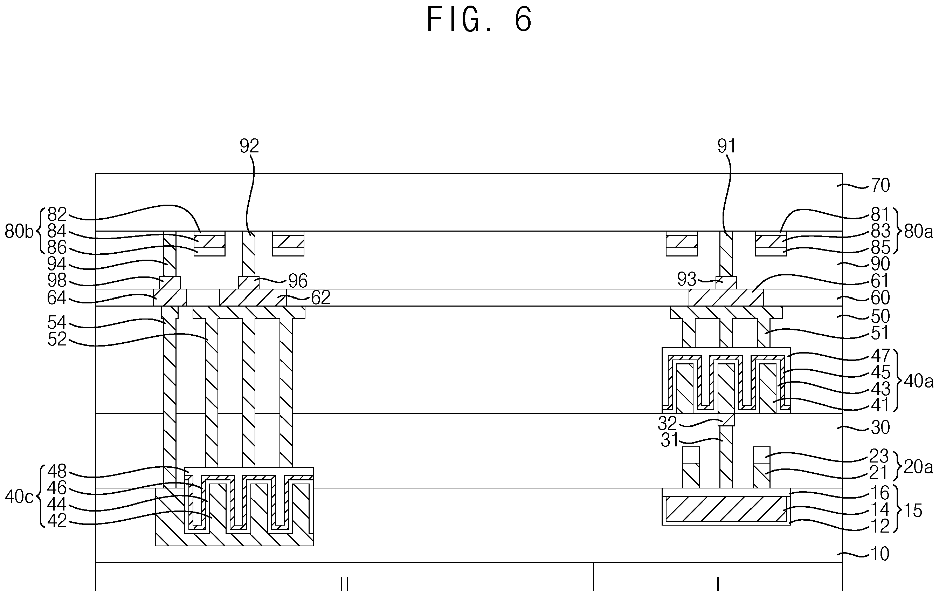

Referring to FIG. 6, instead of the first decoupling capacitor structure 40b in the second insulating interlayer 50, a second decoupling capacitor structure 40c may be formed in the first substrate 10.

The fourth capacitor electrode 42 included in the second decoupling capacitor structure 40c may include a lower portion, which may have a planar shape, and vertical portions, which may extend in the vertical direction on the lower portion and are spaced apart from each other in the horizontal direction. The second dielectric pattern 44, the fifth capacitor electrode 46 and the sixth capacitor electrode 48 may be sequentially stacked on the fourth capacitor electrode 42.

In example embodiments, the second capacitor connection structure 52 may contact an upper surface of the sixth capacitor electrode 48, and the third capacitor connection structure 54 may contact an upper surface of the fourth capacitor electrode 42.

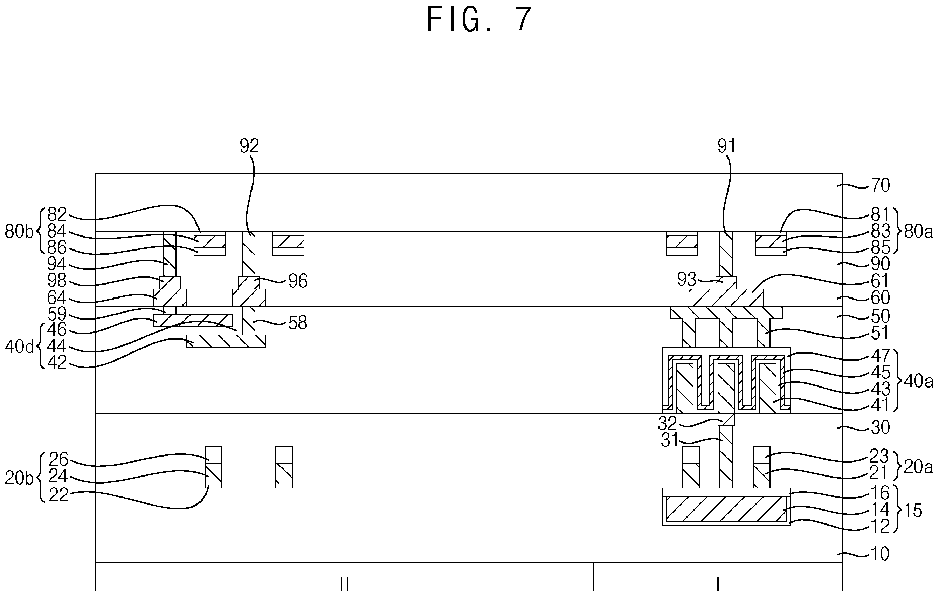

Referring to FIG. 7, a third decoupling capacitor structure 40d may be formed instead of the first decoupling capacitor structure 40b.

In example embodiments, each of the fourth and fifth capacitor electrodes 42 and 46 included in the third decoupling capacitor structure 40d in the second insulating interlayer 50 may have a planar shape extending in the horizontal direction, and the fourth and fifth capacitor electrodes 42 and 46 may at least partially overlap each other. A portion of the second insulating interlayer 50 between the fourth and fifth capacitor electrodes 42 and 46 may operate as a dielectric pattern. Alternatively, the second dielectric pattern 44 may include a material that is different from the material of the second insulating interlayer 50. That is, a high-k dielectric material may be formed between the fourth and fifth capacitor electrodes 42 and 46.

Fourth and fifth capacitor connection structures 58 and 59 that may contact upper surfaces of the fourth and fifth capacitor electrodes 42 and 46, respectively, and lower surfaces of the second and third bonding patterns 62 and 64, respectively, may be formed in the second insulating interlayer 50.

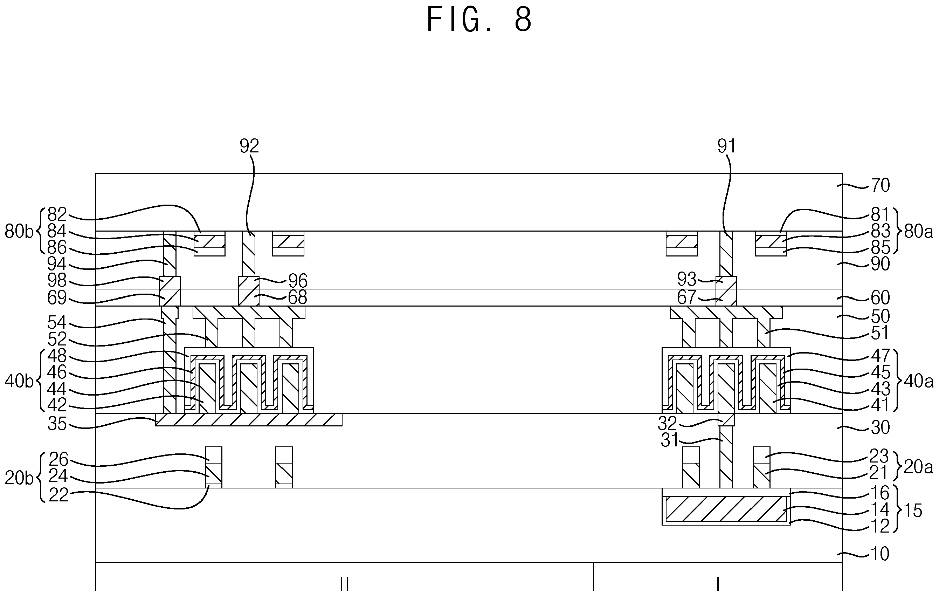

FIG. 8 is a cross-sectional view illustrating a semiconductor device in accordance with example embodiments. This semiconductor device may be substantially the same as or similar to that of FIG. 1, except for not including the bonding layer and the bonding patterns, and thus repeated explanations are omitted herein.

Referring to FIG. 8, unlike the semiconductor device shown in FIG. 1, the semiconductor device may not include the first to third bonding patterns 61, 62 and 64 in the bonding layer 60, and instead, may include first to third conductive connection patterns 67, 68 and 69.

Thus, the first to third capacitor connection structures 51, 52 and 54 may contact the first to third conductive connection patterns 67, 68 and 69, respectively, to be electrically connected to the first to third wirings 93, 96 and 98, respectively. Each of the first to third conductive connection patterns 67, 68 and 69 may include a conductive material, e.g., a metal, a metal nitride, a metal silicide, etc.

Each of the semiconductor device shown in FIGS. 2 to 7 may also include the first to third conductive connection patterns 67, 68 and 69 instead of the first to third bonding patterns 61, 62 and 64.

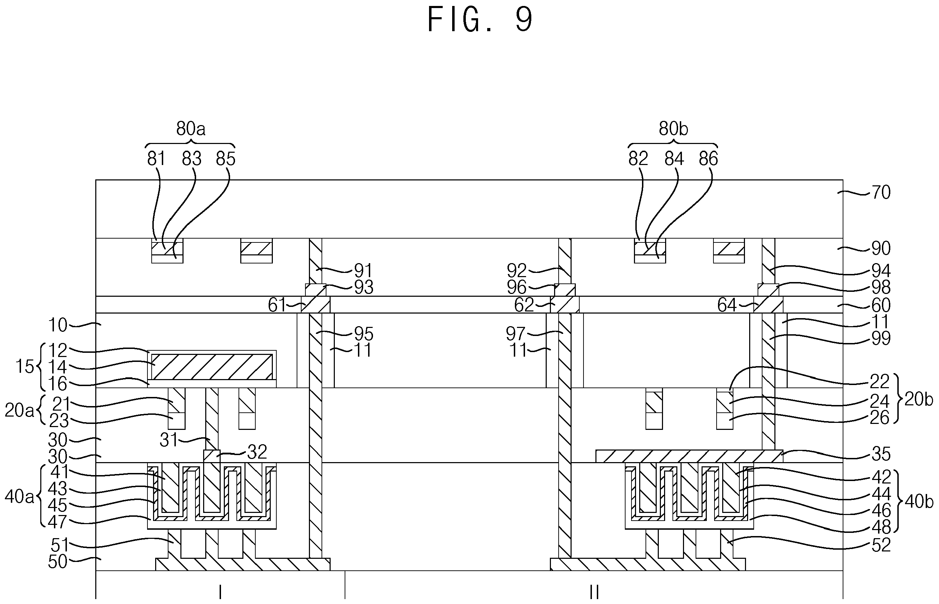

FIGS. 9 to 14 are cross-sectional views illustrating semiconductor devices in accordance with example embodiments. These semiconductor devices may be substantially the same as or similar to that of FIG. 1 or FIG. 8, except for the locations of the structures disposed on or under the first and second substrates, and thus repeated explanations are omitted herein.

Referring to FIG. 9, unlike that of FIG. 1, the first substrate 10, the first insulating interlayer 30 and the second insulating interlayer 50 may be sequentially stacked under the bonding layer 60 in the vertical direction downwardly.

A first insulation pattern 11 may extend through the first substrate 10, and the first and second capacitor connection structures 51 and 52 may be electrically connected to the first and second bonding patterns 61 and 62, respectively, through the first and second through vias 95 and 97, respectively, which may extend through the first insulation pattern 11 and the first and second insulating interlayers 30 and 50.

The conductive pad 35 may be electrically connected to the third bonding pattern 64 by, instead of the third capacitor connection structure 54, a third through via 99, which may extend through the first insulation pattern 11 and the first insulating interlayer 30.

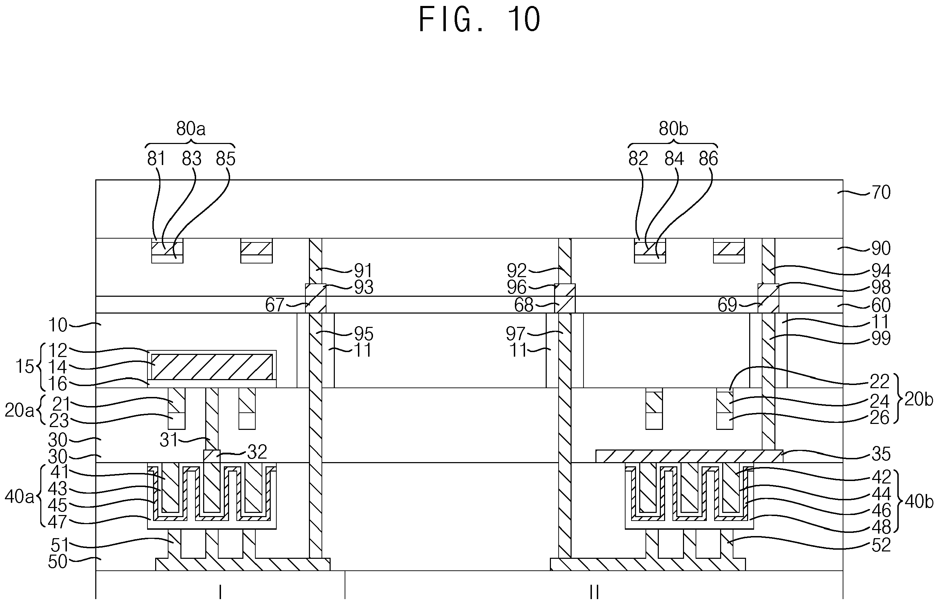

Referring to FIG. 10, the first to third conductive connection patterns 67, 68 and 69, instead of the first to third bonding patterns 61, 62 and 64, may be formed in the bonding layer 60 in the semiconductor device of FIG. 9.

Thus, the first to third through vias 95, 97 and 99 may contact the first to third conductive connection patterns 67, 68 and 69, respectively, to be electrically connected to the first to third wirings 93, 96 and 98, respectively.

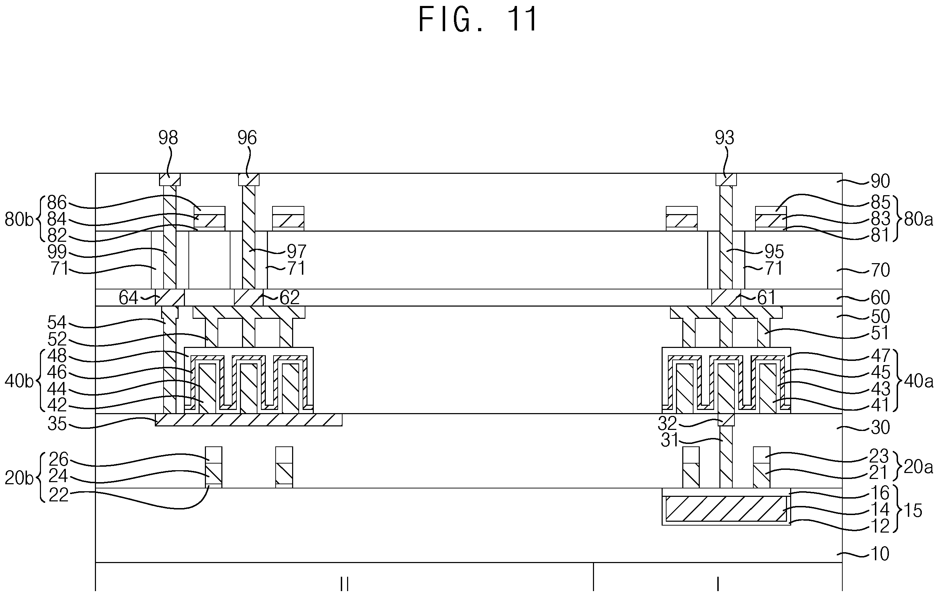

Referring to FIG. 11, and unlike the semiconductor device of FIG. 1, the second substrate 70 and the third insulating interlayer 90 may be sequentially stacked on the bonding layer 60 and the first to third bonding patterns 61, 62 and 64 in the vertical direction upwardly (e.g., away from the first substrate 10).

Thus, the first peripheral circuit transistors including the third and fourth gate structures 80a and 80b, respectively, may be formed on the first and second regions I and II, respectively, of the second substrate 70.

A second insulation pattern 71 may extend through the second substrate 70, and instead of the second to fourth contact plugs 91, 92 and 94, the first to third through vias 95, 97 and 99, which may extend through the second insulation pattern 71 and a lower portion of the third insulating interlayer 90, may be formed. Accordingly, the first to third capacitor connection structures 51, 52 and 54 may be electrically connected to the first to third wirings 93, 96 and 98 by the first to third bonding patterns 61, 62 and 64 and the first to third through vias 95, 97 and 99, respectively.

In example embodiments, each of the first to third through vias 95, 97 and 99 may extend through a corresponding one of the first and second source/drain regions included in the first and second peripheral circuit transistors to be electrically connected thereto.

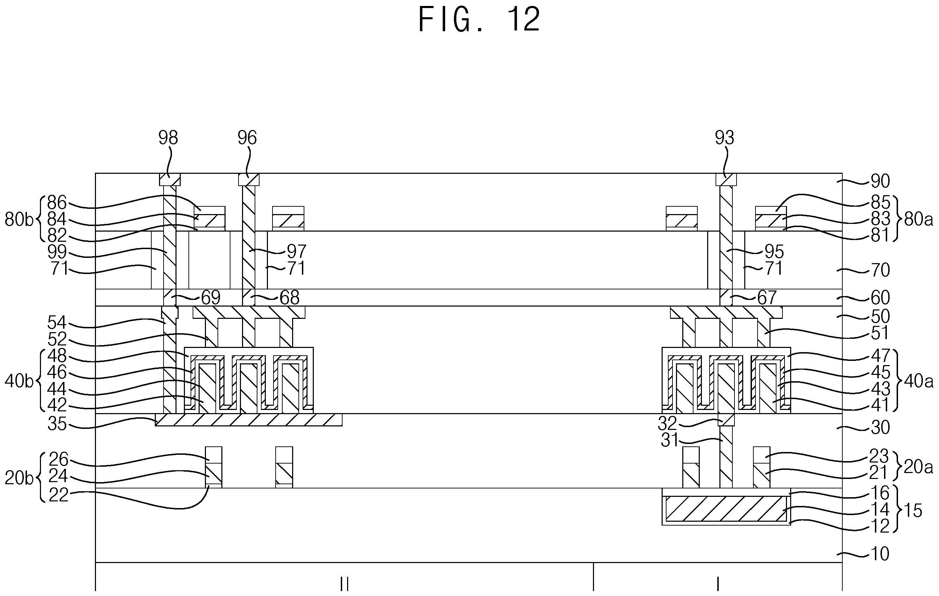

Referring to FIG. 12, the first to third conductive connection patterns 67, 68 and 69, instead of the first to third bonding patterns 61, 62 and 64, may be formed in the bonding layer 60 in the semiconductor device of FIG. 11. Thus, the first to third through vias 95, 97 and 99 may contact the first to third conductive connection patterns 67, 68 and 69, respectively, to be electrically connected to the first to third capacitor connection structures 51, 52 and 54, respectively.

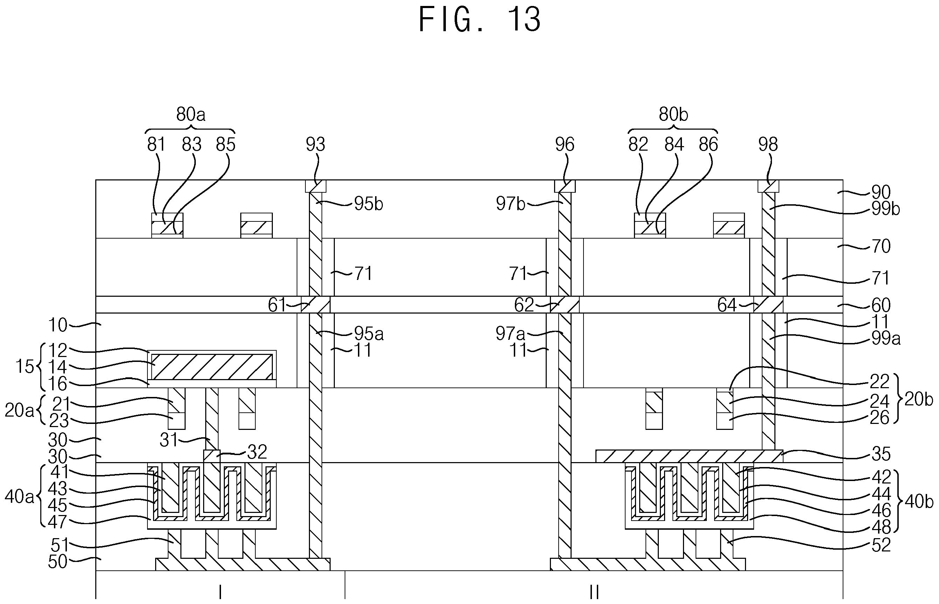

Referring to FIG. 13, and unlike the semiconductor device of FIG. 1, the second insulating interlayer 50, the first insulating interlayer 30, the first substrate 10, the bonding layer 60, the second substrate 70 and the third insulating interlayer 90 may be sequentially stacked in the vertical direction upwardly.

Thus, the first peripheral circuit transistors including the third and fourth gate structures 80a and 80b, respectively, may be formed on the first and second regions I and II, respectively, of the second substrate 70.

The first and second insulation patterns 11 and 71 may be extend through the first and second substrates 10 and 70, respectively. First through vias 95a and 95b may contact the first capacitor connection structure 51, the first bonding pattern 61 and the first wiring 93 to be electrically connected thereto. The second through vias 97a and 97b may contact the second capacitor connection structure 52. The second bonding pattern 62 and the second wiring 96 to be electrically connected thereto, and the third through vias 99a and 99b may contact the conductive pad 35, the third bonding pattern 64 and the third wiring 98 to be electrically connected thereto.

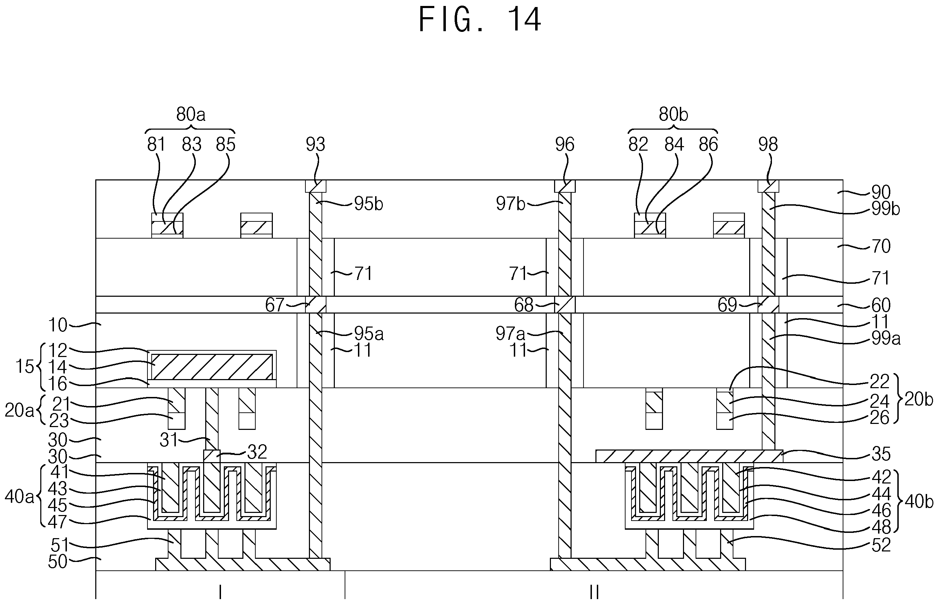

Referring to FIG. 14, instead of the first to third bonding patterns 61, 62 and 64, the first to third conductive connection patterns 67, 68 and 69 may be formed in the bonding layer 60 in the semiconductor device of FIG. 13.

The semiconductor device may have a periphery over cell (POC) structure including the second substrate 70 and the first and second peripheral circuit transistors having the third and fourth gate structures 80a and 80b, respectively, over the first substrate 10, the cell capacitor structure 40a and the first decoupling capacitor structure 40b. However, the present disclosure may not be limited thereto, and the semiconductor device may have a cell over periphery (COP) structure, as described below in further detail.

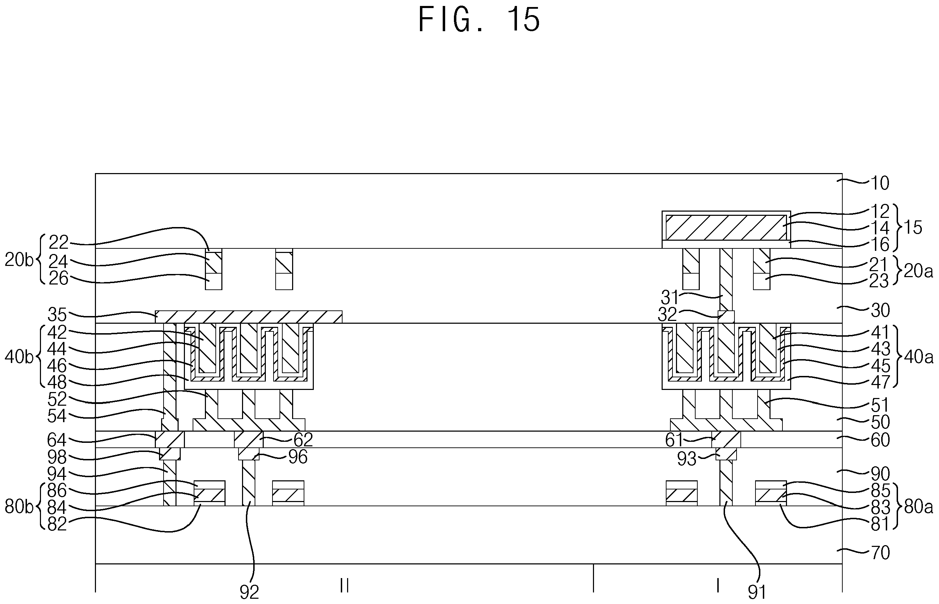

FIGS. 15 to 22 are cross-sectional views illustrating semiconductor devices in accordance with example embodiments. These semiconductor devices may be substantially the same as or similar to that of FIG. 1 or FIG. 8, except for the locations of the first and second substrates and the structures disposed on or under the first and second substrates, and thus repeated explanations are omitted herein.

Referring to FIG. 15, the orientation of the semiconductor device of FIG. 1 may be flipped such that the relative positions of the first and second substrates 10 and 70 may be changed, and the third insulating interlayer 90, the bonding layer 60, the second insulating interlayer 50, the first insulating interlayer 30 and the first substrate 10 may be sequentially stacked in the vertical direction upwardly.

Accordingly, the first and second peripheral circuit transistors may be disposed on the first and second regions I and II, respectively, of the second substrate 70, and the cell capacitor structure 40a and the first decoupling capacitor structure 40b may be disposed under the first and second regions I and II, respectively, of the first substrate 10.

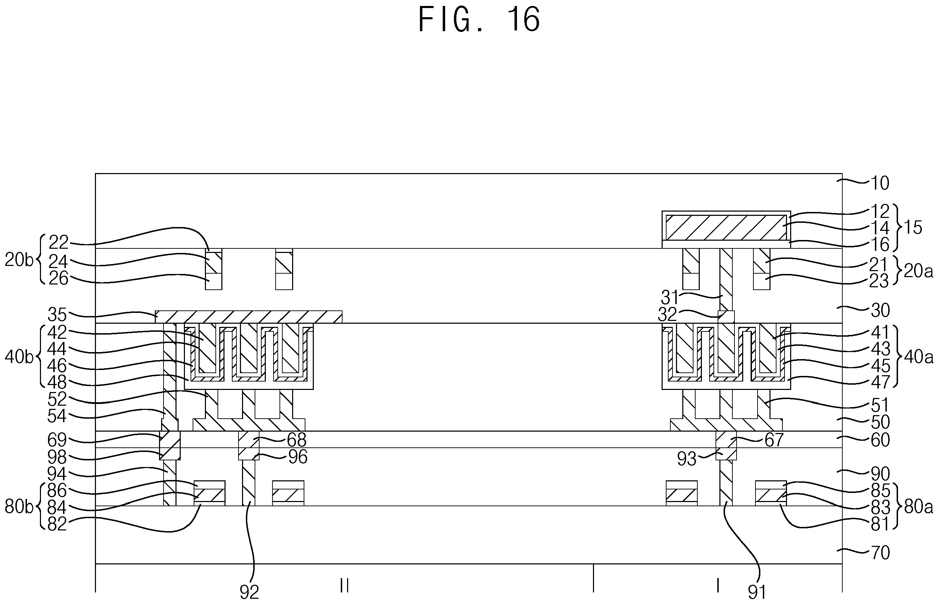

Referring to FIG. 16, instead of the first to third bonding patterns 61, 62 and 64, the first to third conductive connection patterns 67, 68 and 69 may be formed in the bonding layer 60 in the semiconductor device of FIG. 15.

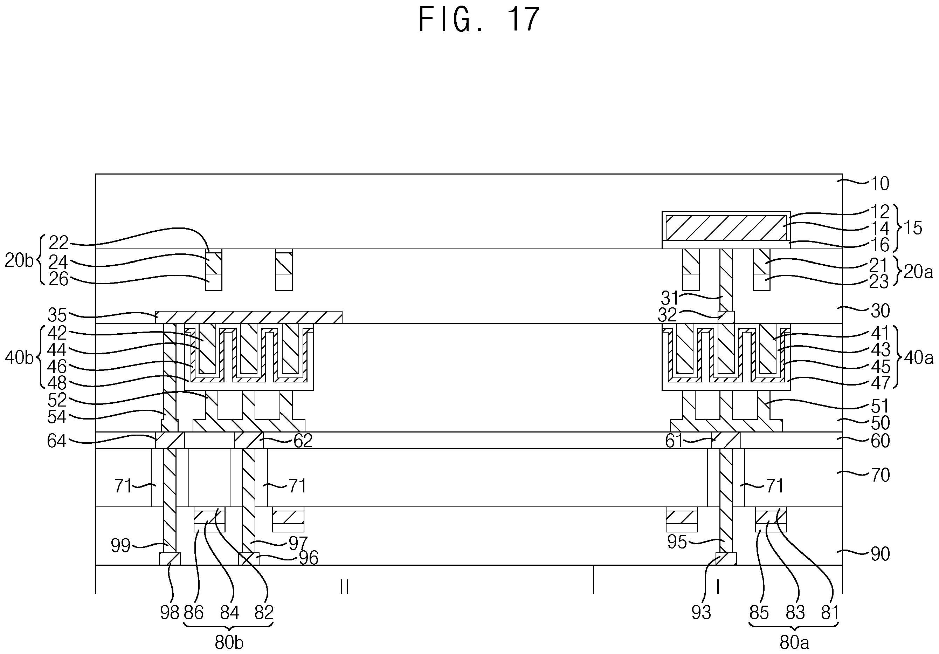

Referring to FIG. 17, and unlike the embodiment of FIG. 15, the second substrate 70 and the third insulating interlayer 90 may be sequentially stacked in the vertical direction downwardly (e.g., away from the first substrate 10) under the bonding layer 60.

The second insulation pattern 71 may extend through the second substrate 70, and each of the first to third through vias 95, 97 and 99 may extend through the second insulation pattern 71 and an upper portion of the third insulating interlayer 90. The first to third capacitor connection structures 51, 52 and 54 may be electrically connected to the first to third wirings 93, 96 and 98, respectively, by the first to third bonding patterns 61, 62 and 64 and the first to third through vias 95, 97 and 99, respectively.

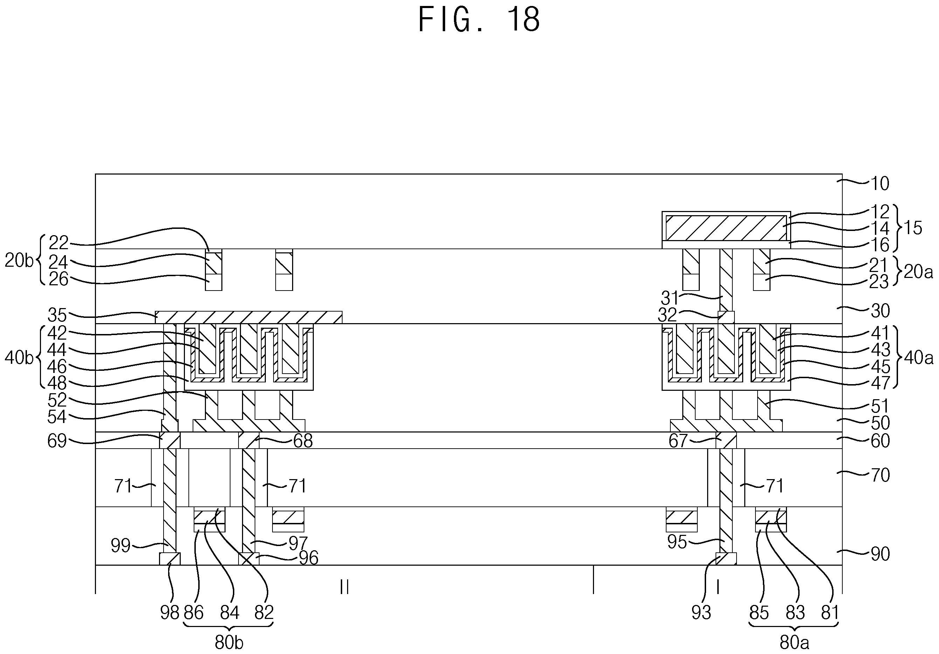

Referring to FIG. 18, instead of the first to third bonding patterns 61, 62 and 64, the first to third conductive connection patterns 67, 68 and 69 may be formed in the bonding layer 60 in the semiconductor device of FIG. 17. Thus, the first to third capacitor connection structures 51, 52 and 54 may contact the first to third conductive connection patterns 67, 68 and 69, respectively, to be electrically connected to the first to third through vias 95, 97 and 99 and the first to third wirings 93, 96 and 98, respectively.

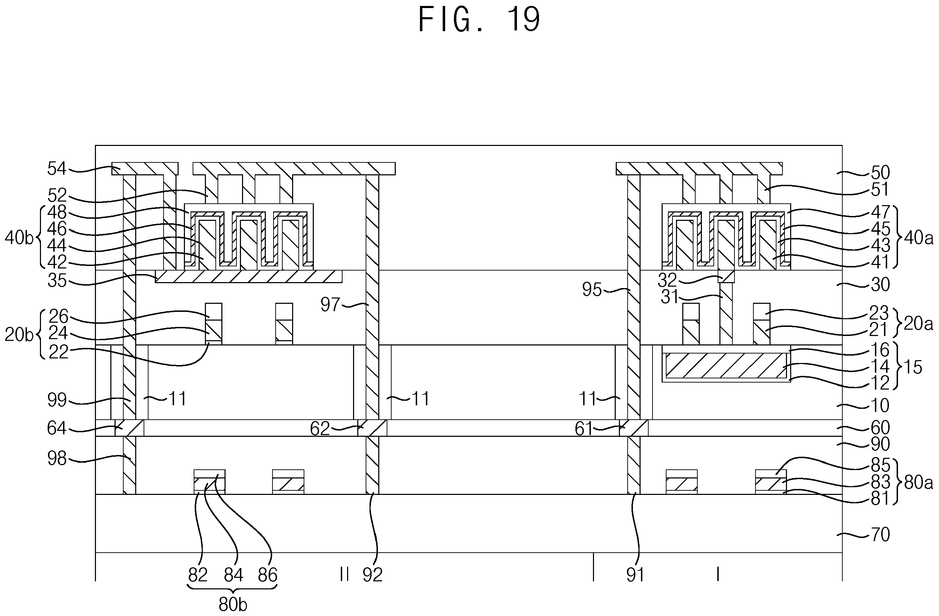

Referring to FIG. 19, and unlike the embodiment of FIG. 15, the first substrate 10, the first insulating interlayer 30 and the second insulating interlayer 50 may be sequentially stacked on the bonding layer 60 in the vertical direction upwardly, and the first insulation pattern 11 may extend through the first substrate 10.

The first to third through vias 95, 97 and 99 may extend through the first insulation pattern 11, the first insulating interlayer 30 and the lower portion of the second insulating interlayer 50 to contact the first to third capacitor connection structures 51, 52 and 54, respectively, and may be electrically connected thereto.

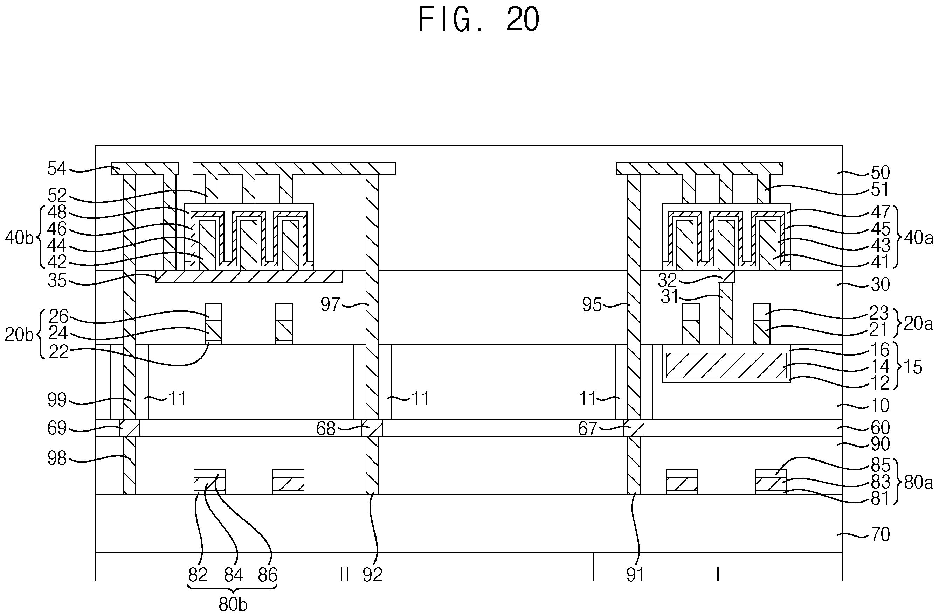

Referring to FIG. 20, instead of the first to third bonding patterns 61, 62 and 64, the first to third conductive connection patterns 67, 68 and 69 may be formed in the bonding layer 60 in the semiconductor device of FIG. 19.

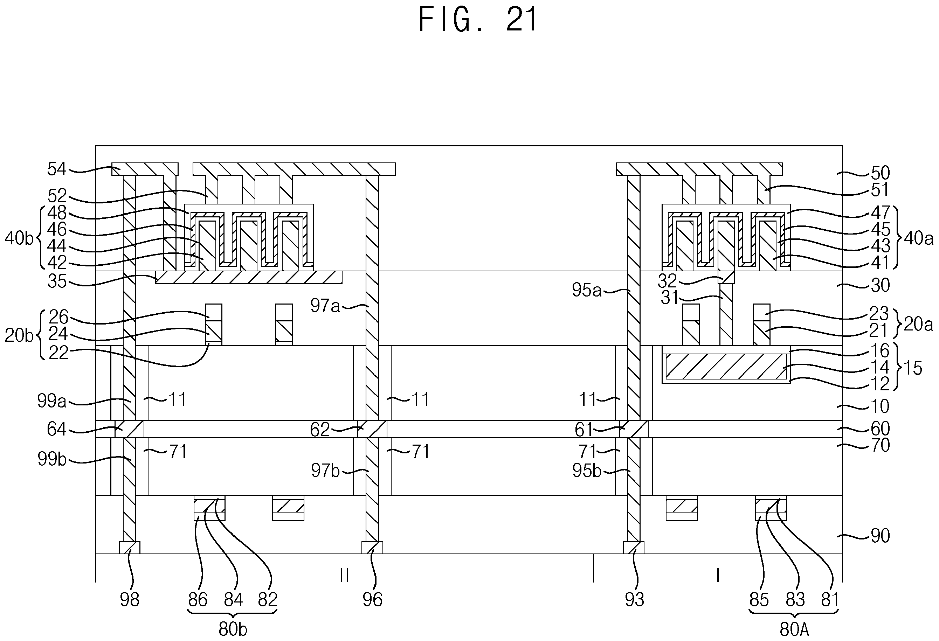

Referring to FIG. 21, and unlike the embodiment of FIG. 15, the second substrate 70 and the third insulating interlayer 90 may be sequentially stacked under the bonding layer 60 in the vertical direction downwardly.

Thus, the first and second peripheral circuit transistors including the third and fourth gate structures 80a and 80b, respectively, may be formed under the first and second regions I and II, respectively, of the second substrate 70.

The first and second insulation patterns 11 and 71 may extend through the first and second substrates 10 and 70, respectively. The first through vias 95a and 95b may contact the first capacitor connection structure 51, the first bonding pattern 61 and the first wiring 93 to be electrically connected thereto. The second through vias 97a and 97b may contact the second capacitor connection structure 52, the second bonding pattern 62 and the second wiring 96 to be electrically connected thereto. The third through vias 99a and 99b may contact the conductive pad 35, the third bonding pattern 64 and the third wiring 98 to be electrically connected thereto.

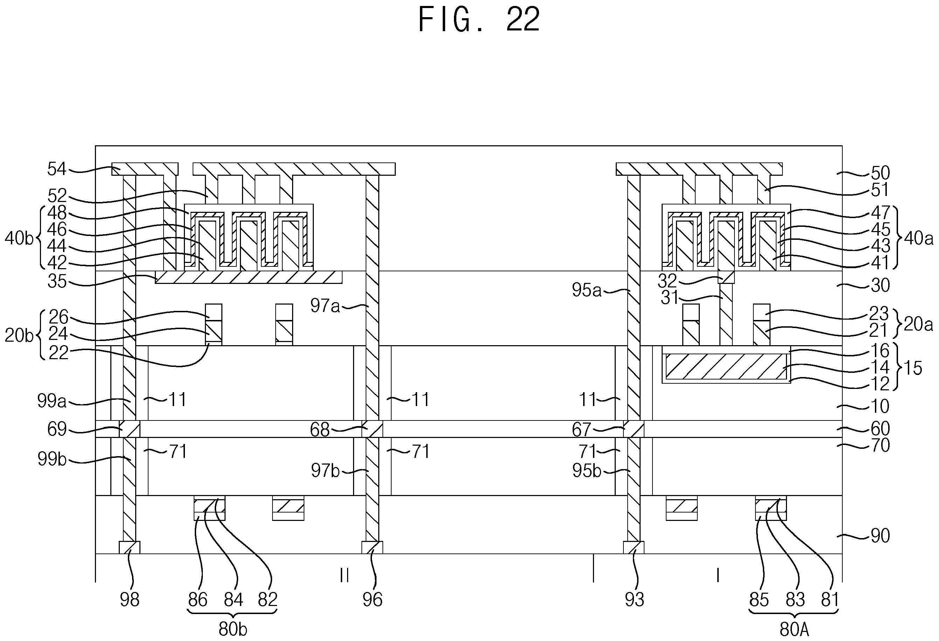

Referring to FIG. 22, instead of the first to third bonding patterns 61, 62 and 64, the first to third conductive connection patterns 67, 68 and 69 may be formed in the bonding layer 60 in the semiconductor device of FIG. 21.

Each of the semiconductor devices shown in FIGS. 9 to 22 may be applied to the semiconductor devices of FIGS. 2 to 7 as well as the semiconductor device of FIGS. 1 and 8.

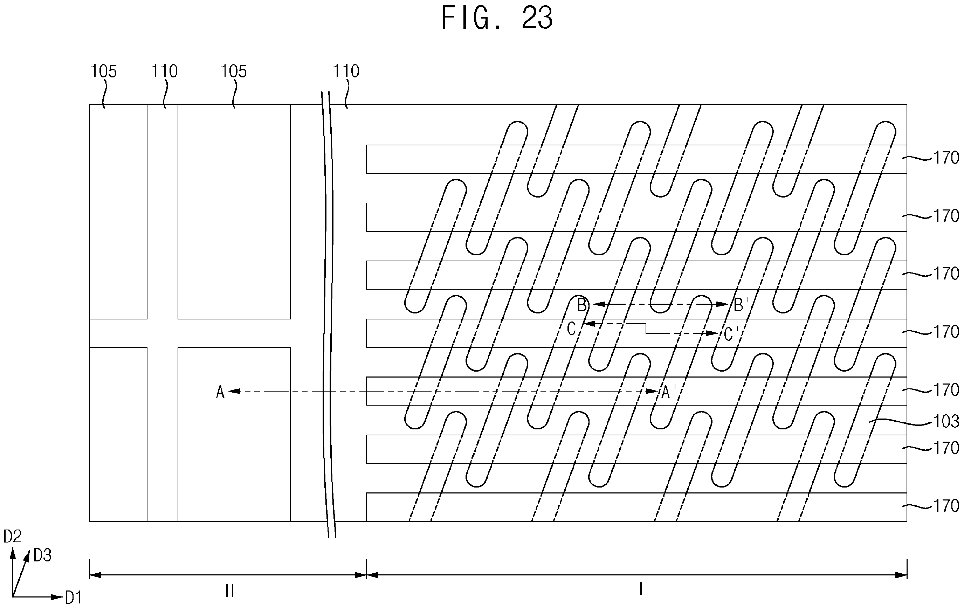

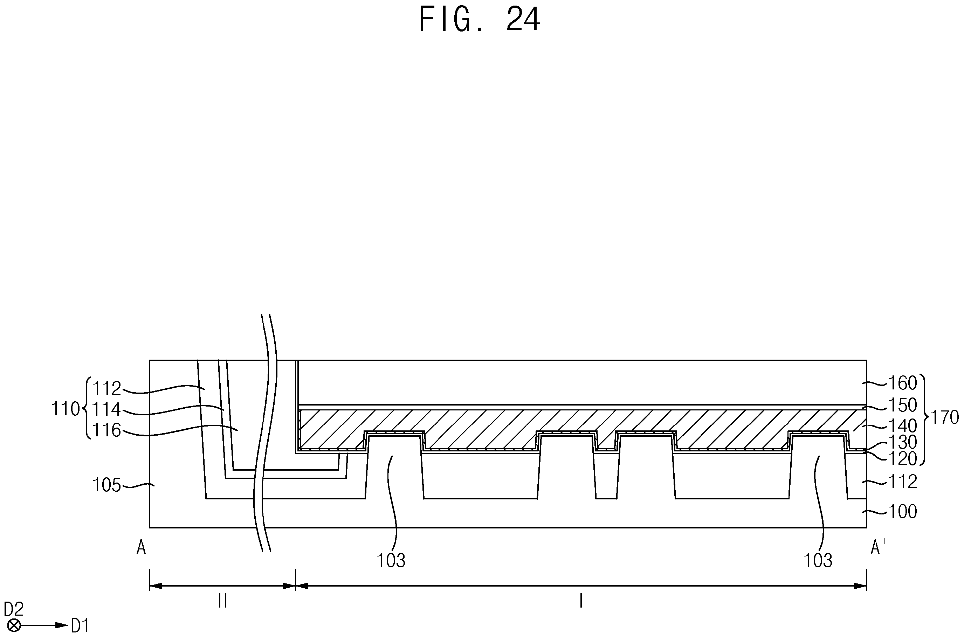

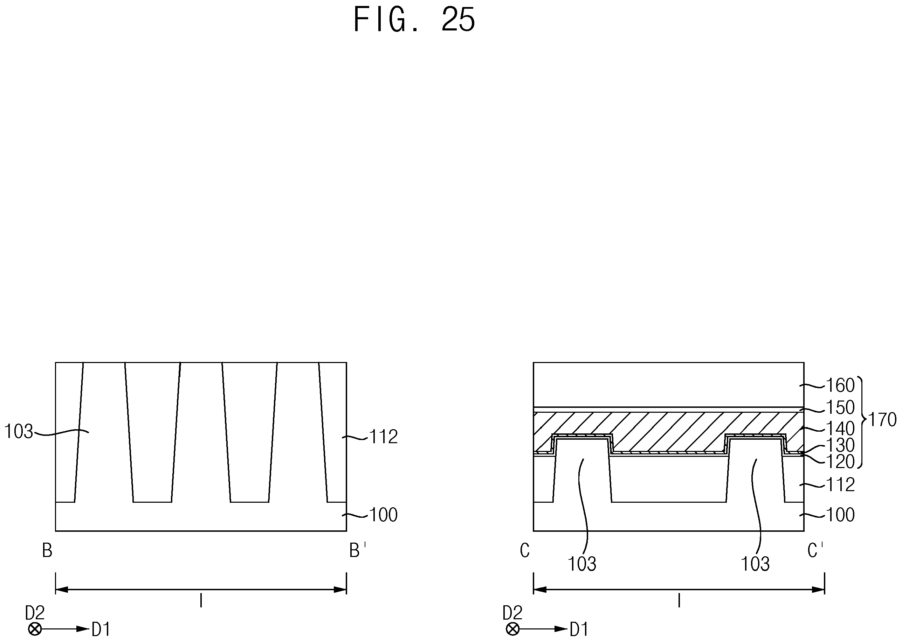

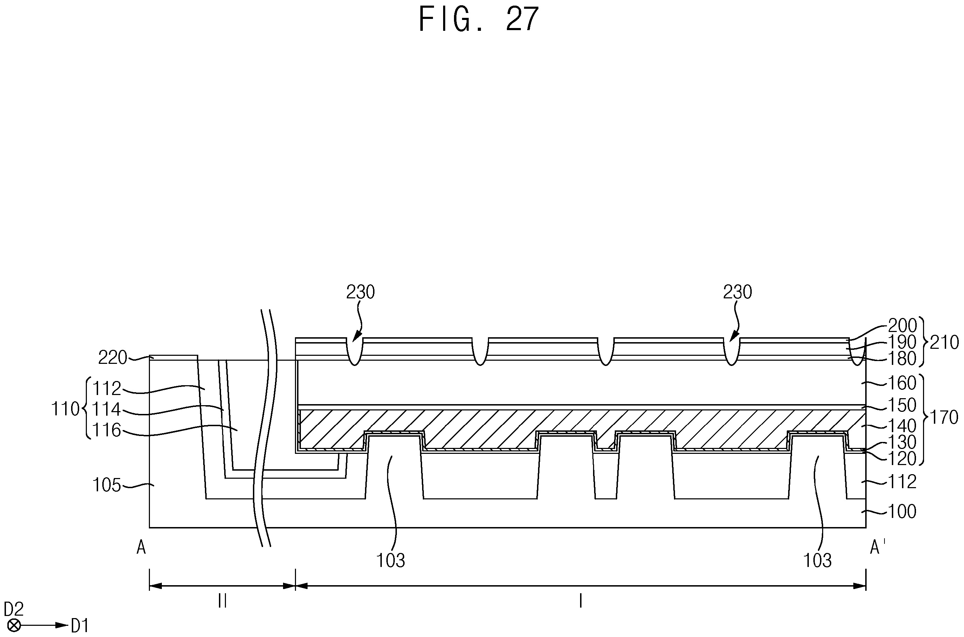

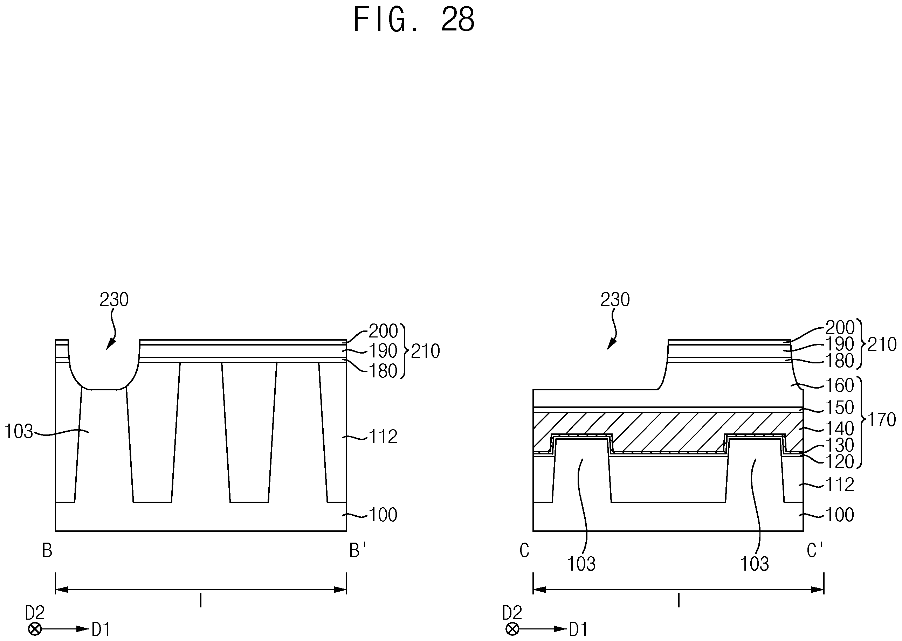

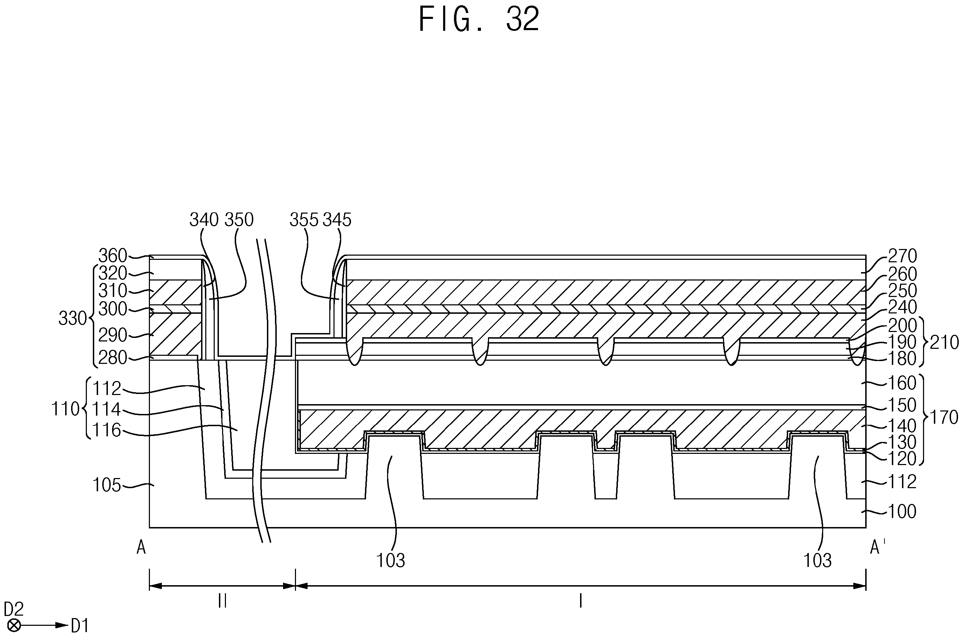

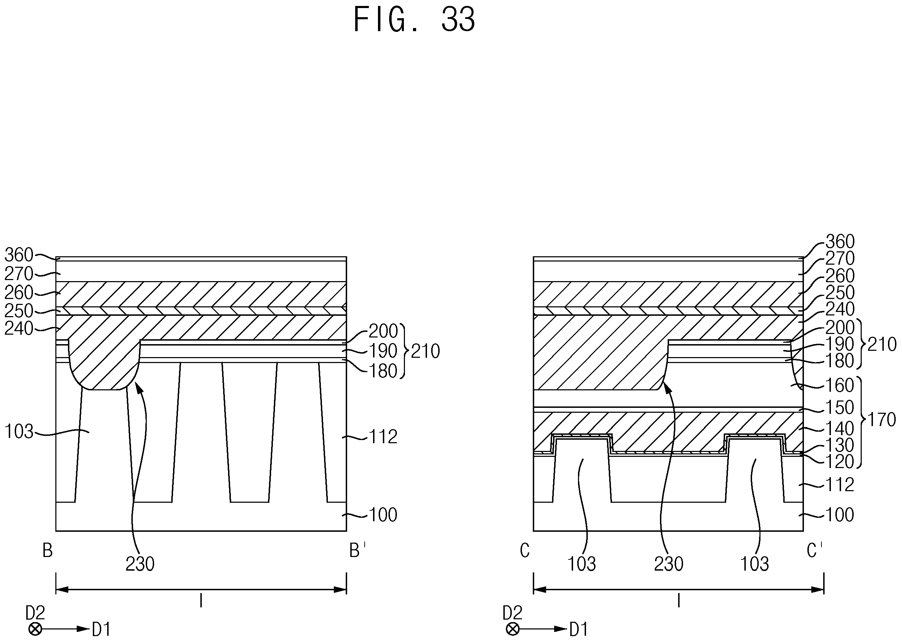

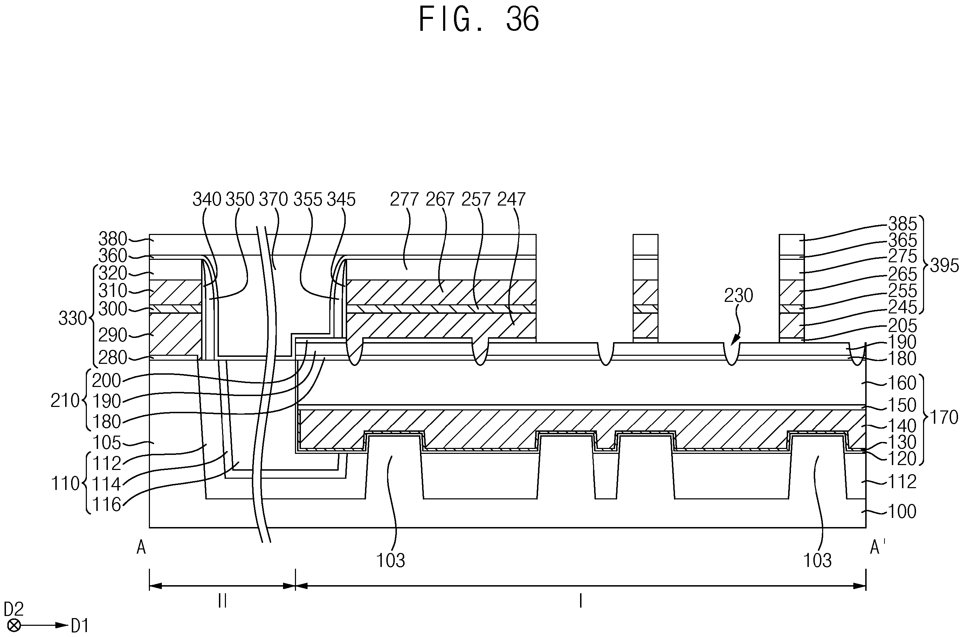

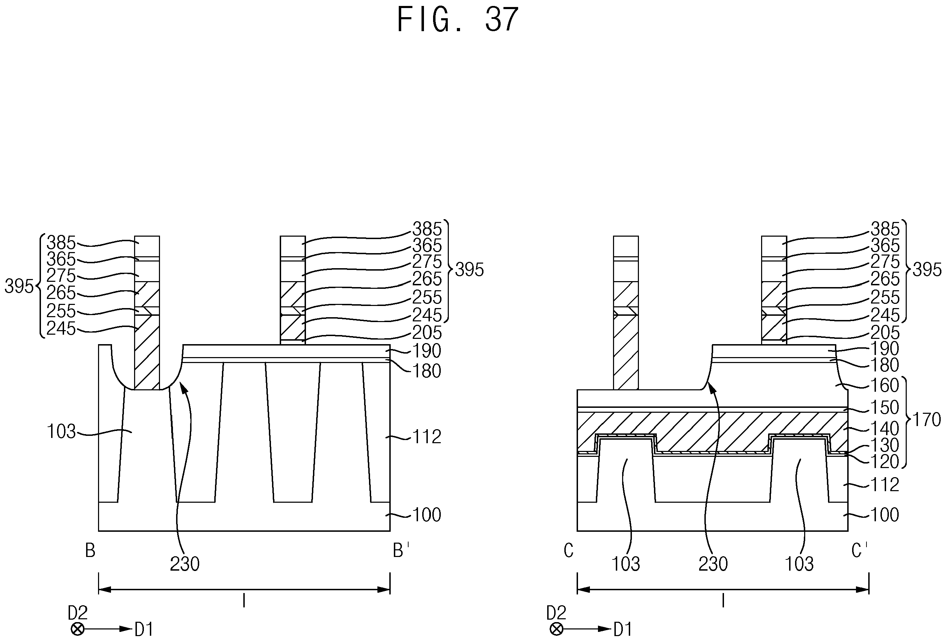

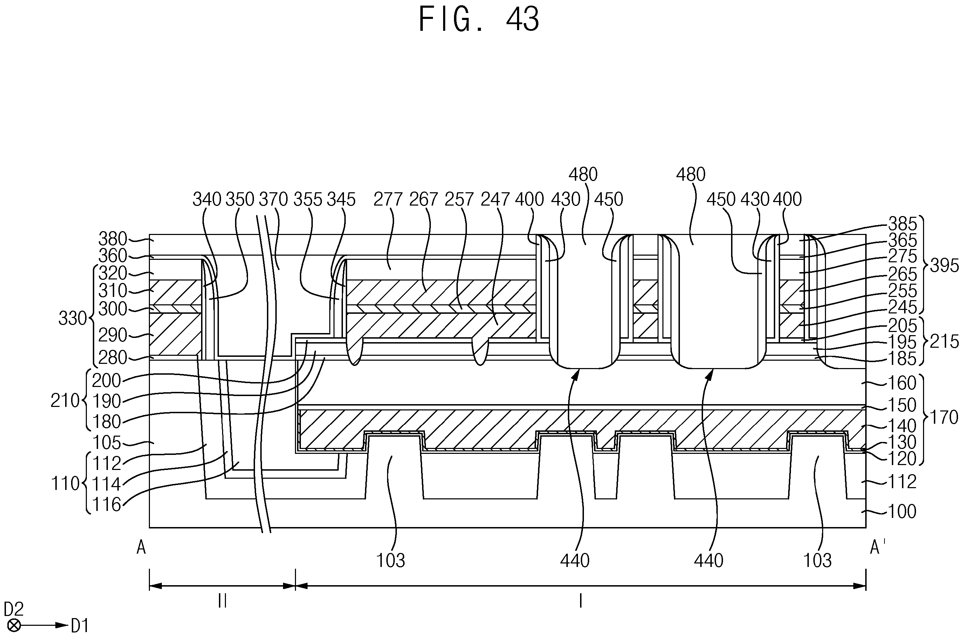

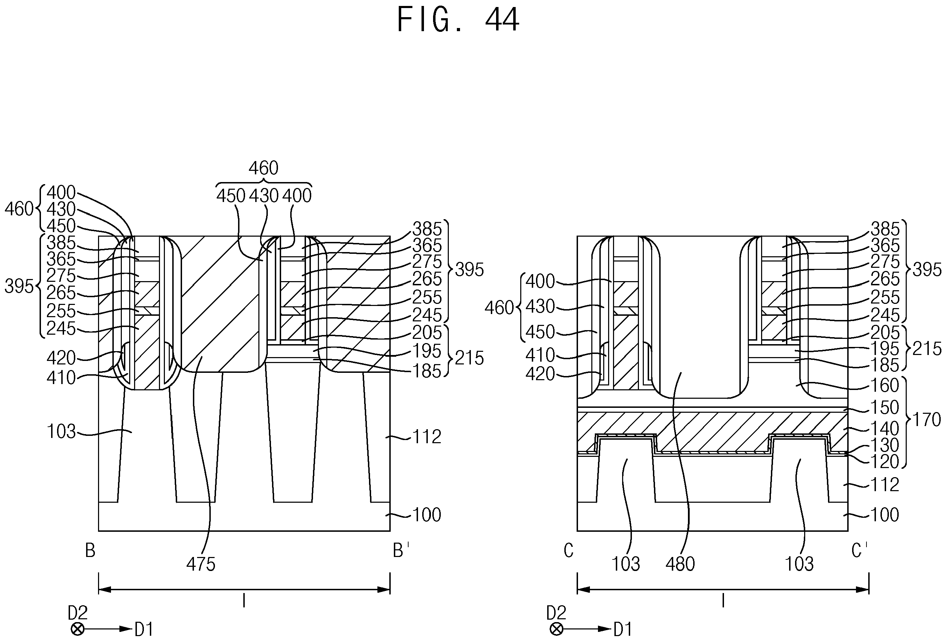

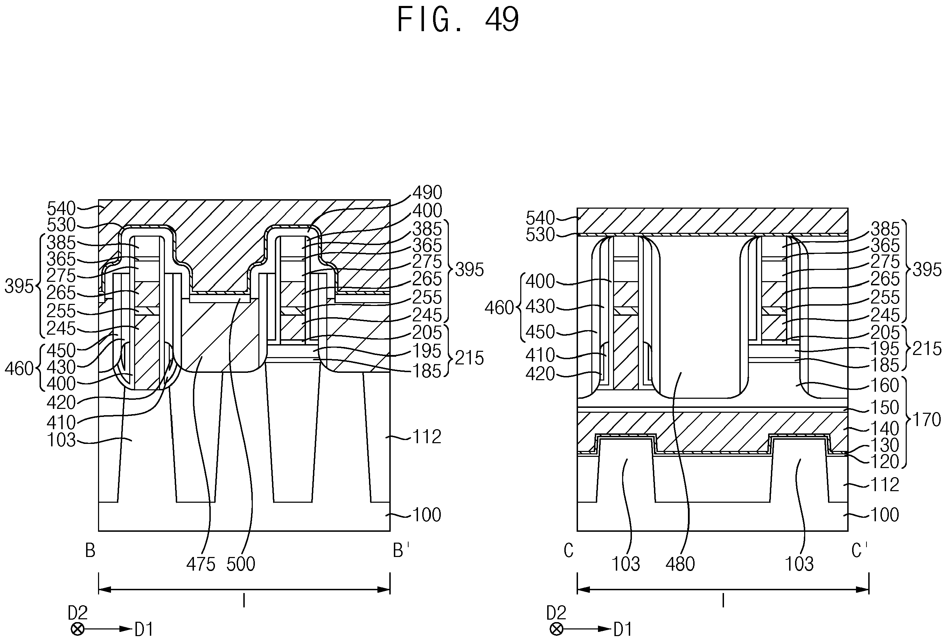

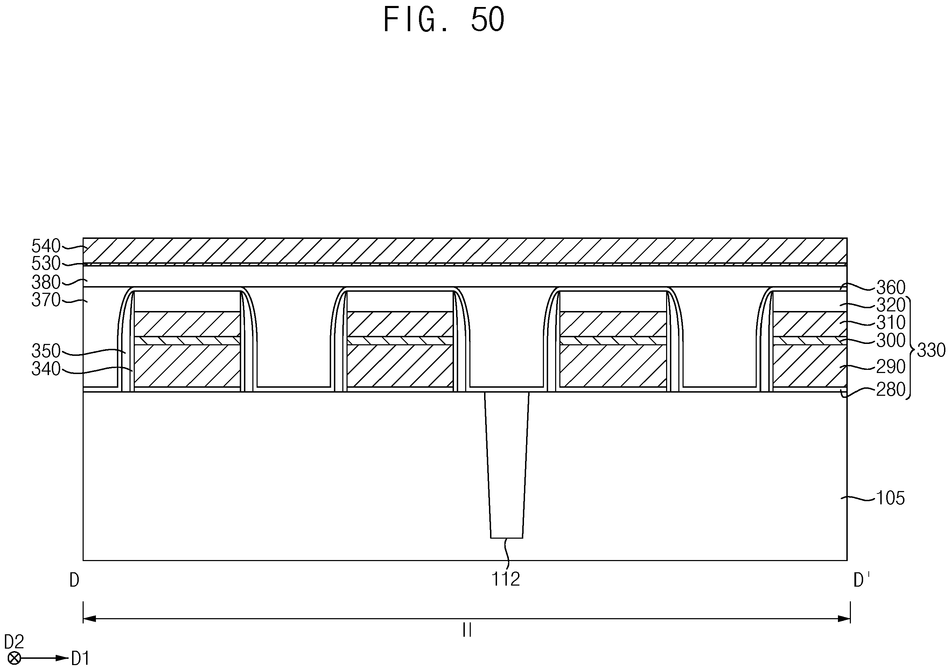

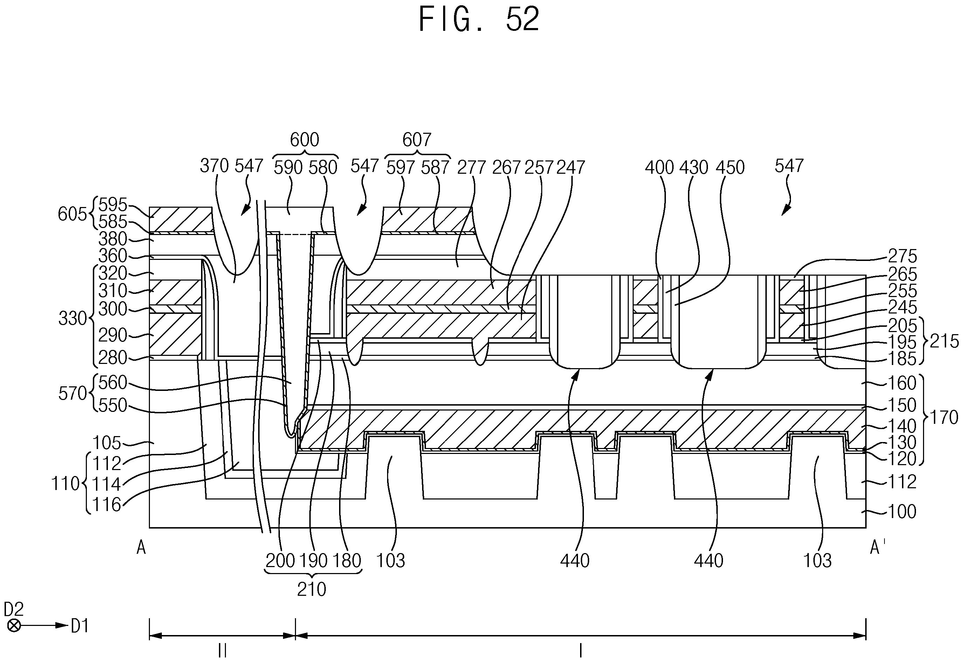

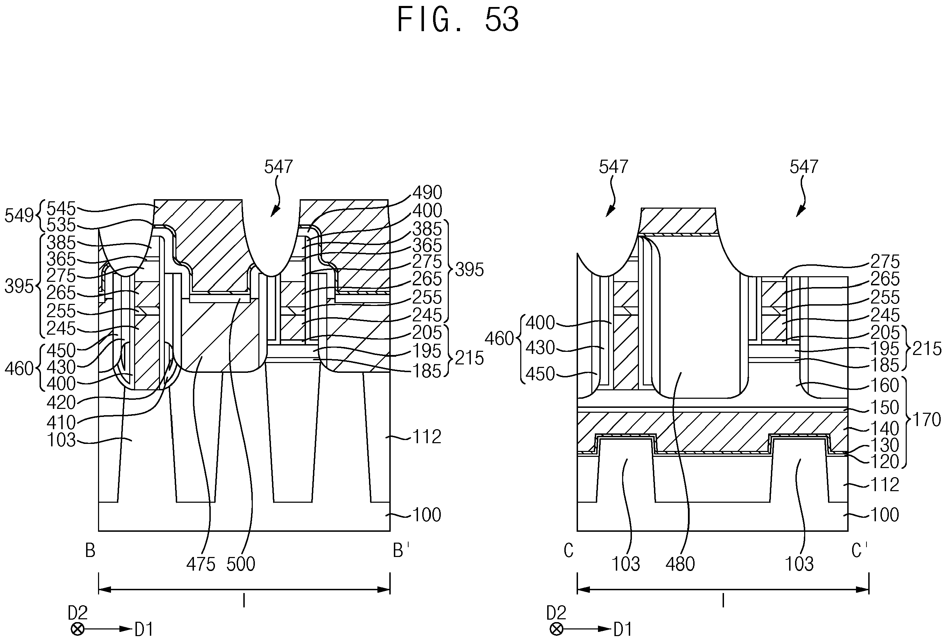

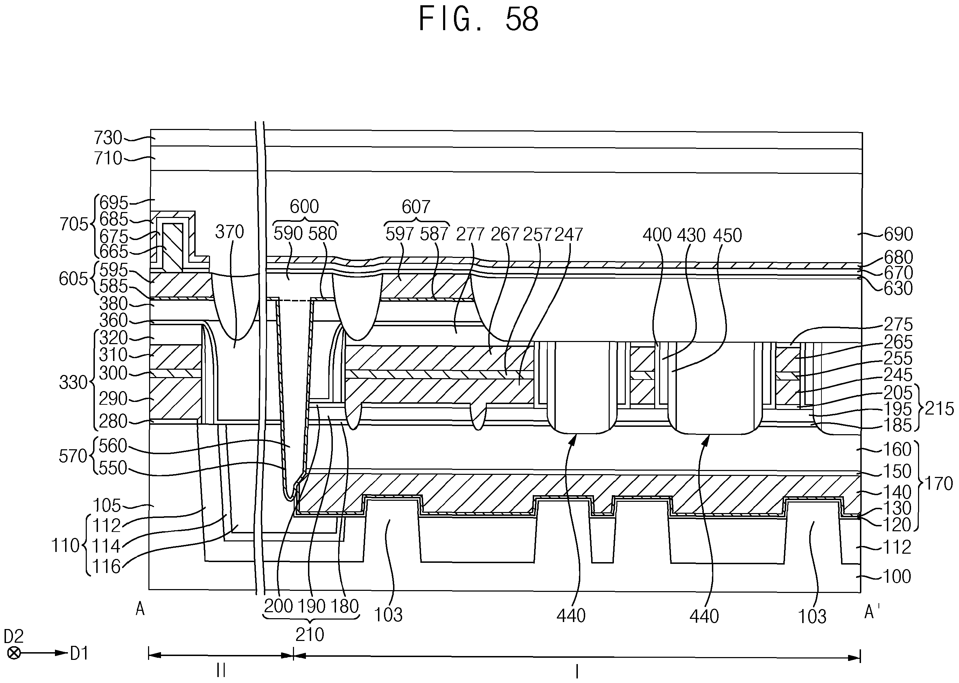

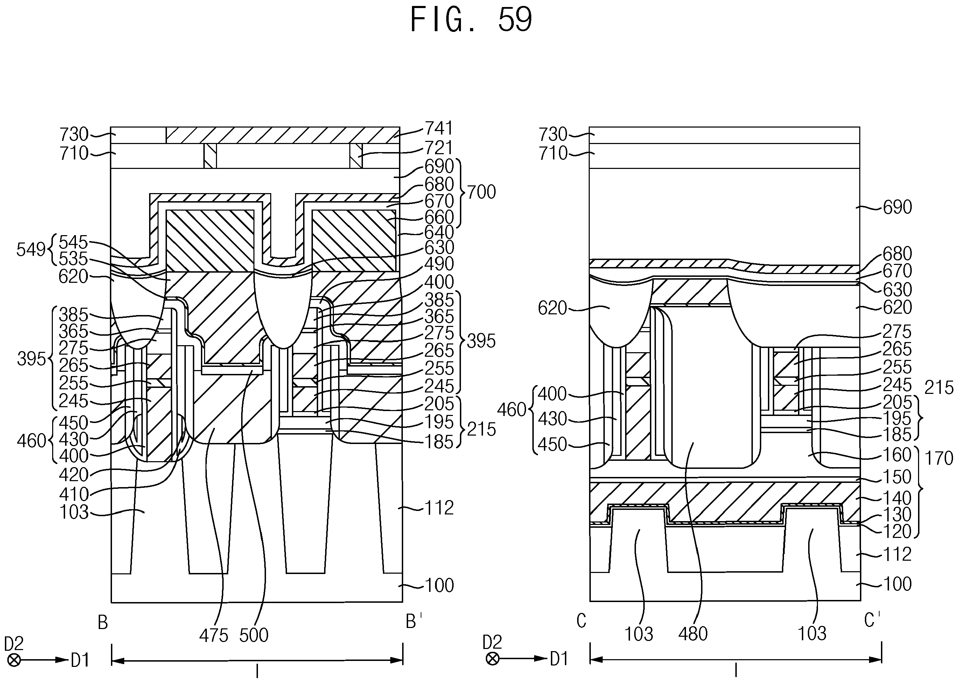

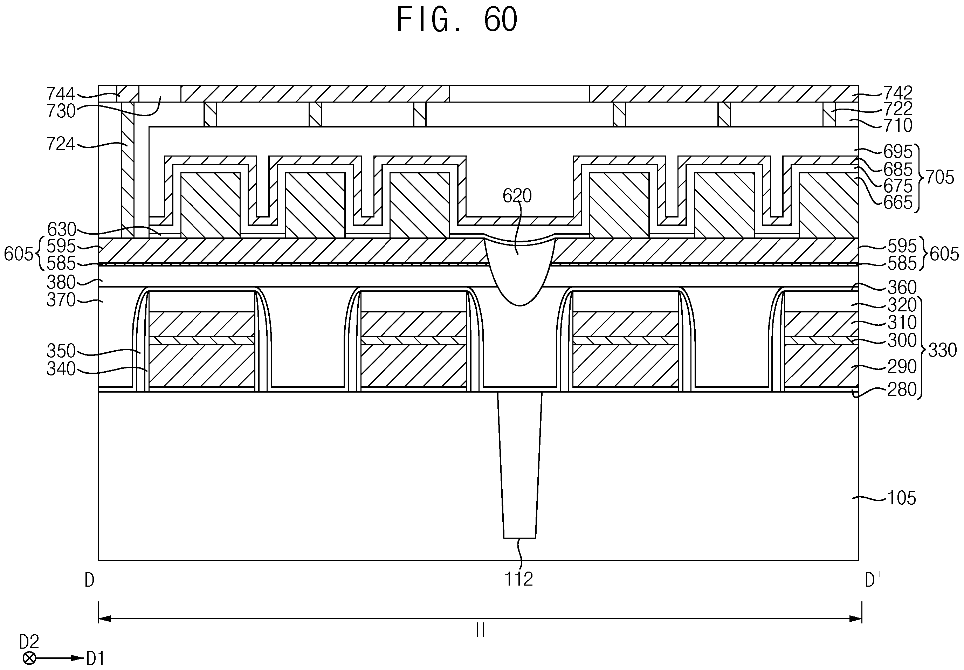

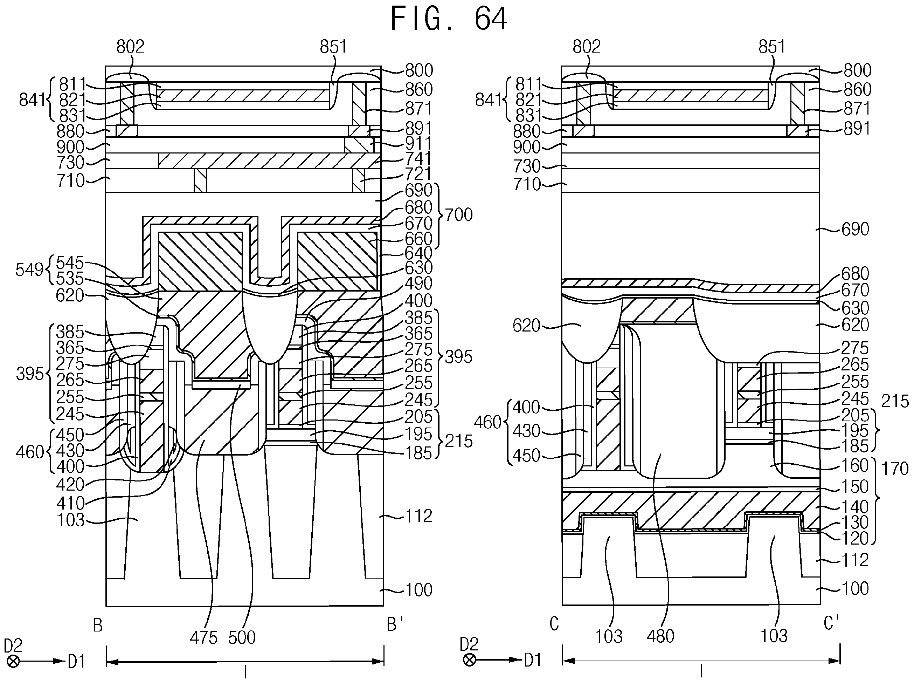

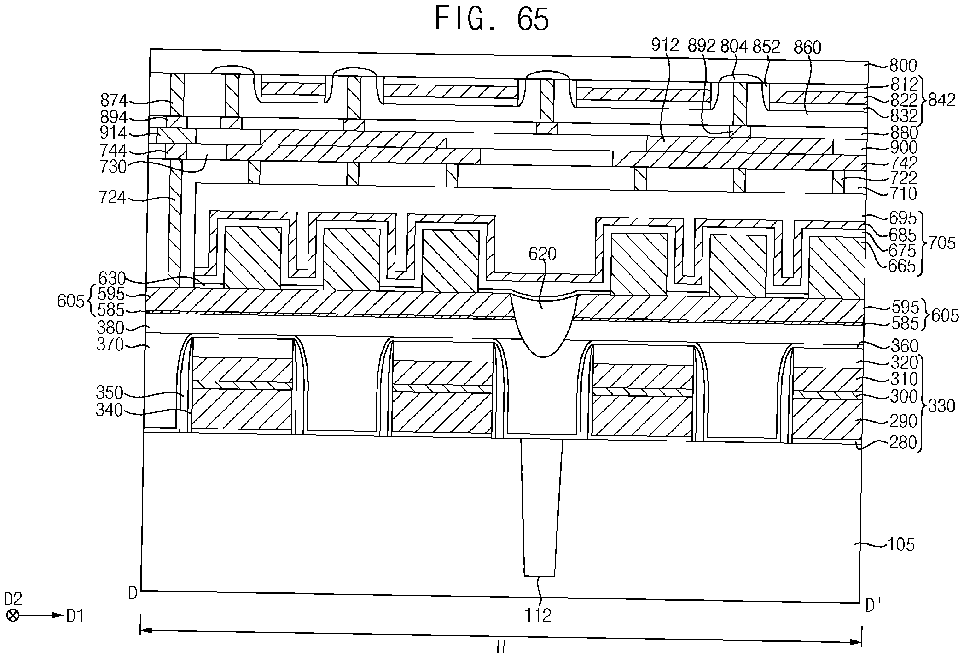

FIGS. 23 to 65 are plan views and cross-sectional views illustrating a method of manufacturing a semiconductor device according to example embodiments. Specifically, FIGS. 23, 26, 31, 35, 42, 46, 51 and 57 are the plan views, FIGS. 24, 27, 29, 32, 34, 36, 38, 40, 43, 47-48, 52, 58, 61 and 63 are cross-sectional views taken along lines A-A' of corresponding plan views. FIGS. 25, 28, 30, 33, 37, 39, 41, 44-45, 49, 53, 55, 59 and 64 include cross-sections taken along lines B-B' and C-C' of a corresponding plan view, and FIGS. 50, 54, 56, 60, 62 and 65 are cross-sectional views taken along lines D-D' of corresponding plan views.

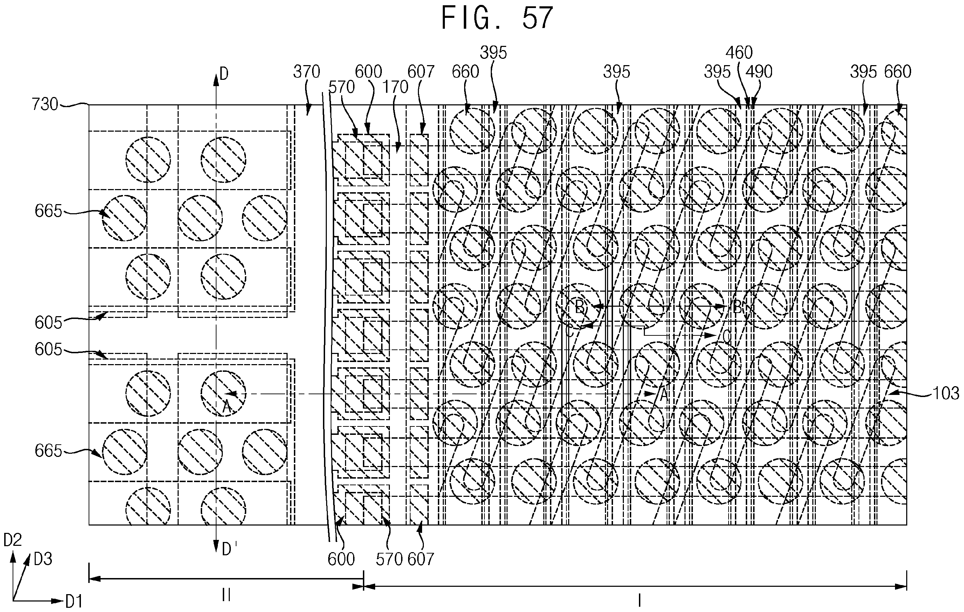

In FIG. 57, some of the structures, e.g., sixth to eighth wirings 741, 742 and 744 are not shown to avoid the complexity of the drawing.

This method may include more particular processes for implementing the present disclosure of the semiconductor device of FIG. 1, and the present disclosure of the semiconductor devices of FIGS. 2 to 22 may also be implemented by processes substantially the same as or similar to the processes.

Hereinafter, in the specification (and not necessarily in the claims), two directions substantially parallel to an upper surface of a first substrate 100 and substantially perpendicular to each other may be referred to as first and second directions D1 and D2, respectively, and a direction substantially parallel to the upper surface of the first substrate 100 and having an acute angle with respect to the first and second directions D 1 and D2 may be referred to as a third direction D3. Additionally, a direction substantially perpendicular to the upper surface of the first substrate 100 may be referred to as a vertical direction.

Referring to FIGS. 23 to 25, first and second active patterns 103 and 105 may be formed on the first substrate 100 including first and second regions I and II, and an isolation pattern structure 110 may be formed to cover or overlap sidewalls of the first and second active patterns 103 and 105.

The first region I of the first substrate 100 may be a cell region on which memory cells are formed, and the second region II of the first substrate 100 may be a peripheral circuit region on which peripheral circuit patterns for driving the memory cells are formed.

The first and second active patterns 103 and 105 may be formed by removing an upper portion of the first substrate 100 to form a first recess. The first active pattern 103 may extend in the third direction D3, and a plurality of first active patterns 103 may be spaced apart from each other in each of the first and second directions D1 and D2. Additionally, a plurality of second active patterns 105 may be spaced apart from each other in each of the first and second directions D1 and D2, and FIG. 23 shows some of the second active patterns 105.

In example embodiments, the isolation pattern structure 110 may include first to third isolation patterns 112, 114 and 116 sequentially stacked on an inner wall of the first recess. A portion of the first recess in the first region I of the first substrate 100 or in a portion of the second region II of the first substrate 100 may have a relatively small width, and thus only the first isolation pattern 112 may be formed in the portion of the first recess. However, a portion of the first recess in a portion of the second region II or between the first and second regions I and II of the first substrate 100 may have a relatively large width, and thus all of the first to third isolation patterns 112, 114 and 116 may be formed in the portion of the first recess.

The first and third isolation patterns 112 and 116 may have an oxide, e.g., silicon oxide, and the second isolation pattern 114 may include a nitride, e.g., silicon nitride.

The first active pattern 103 and the isolation pattern structure 110 in the first region I of the first substrate 100 may be partially removed to form a second recess extending in the first direction D 1.

A first gate structure 170 may be formed in the second recess. In example embodiments, the first gate structure 170 may include a first gate insulation pattern 120 on a bottom and a sidewall of the second recess, a first barrier pattern 130 on a portion of the first gate insulation pattern 120 on the bottom and a lower sidewall of the second recess, a first conductive pattern 140 on the first barrier pattern 130 and filling or in a lower portion of the second recess, a second conductive pattern 150 on the first barrier pattern 130 and the first conductive pattern 140, and a first gate mask 160 on an upper surface of the second conductive pattern 150 and an upper inner sidewall of the first gate insulation pattern 120 and filling or in an upper portion of the second recess. The first barrier pattern 130, the first conductive pattern 140 and the second conductive pattern 150 may form a first gate electrode.

The first barrier pattern 130 may include a metal nitride, e.g., titanium nitride, tantalum nitride, etc. The first conductive pattern 140 may include a metal, a metal nitride, a metal silicide, doped polysilicon, etc., and the second conductive pattern 150 may include doped polysilicon.

In example embodiments, the first gate structure 170 may extend in the first direction D1 on the first region I of the first substrate 100, and a plurality of first gate structures 170 may be spaced apart from each other in the second direction D2. End portions in the first direction D1 of the first gate structures 170 may be aligned with each other in the second direction D2.

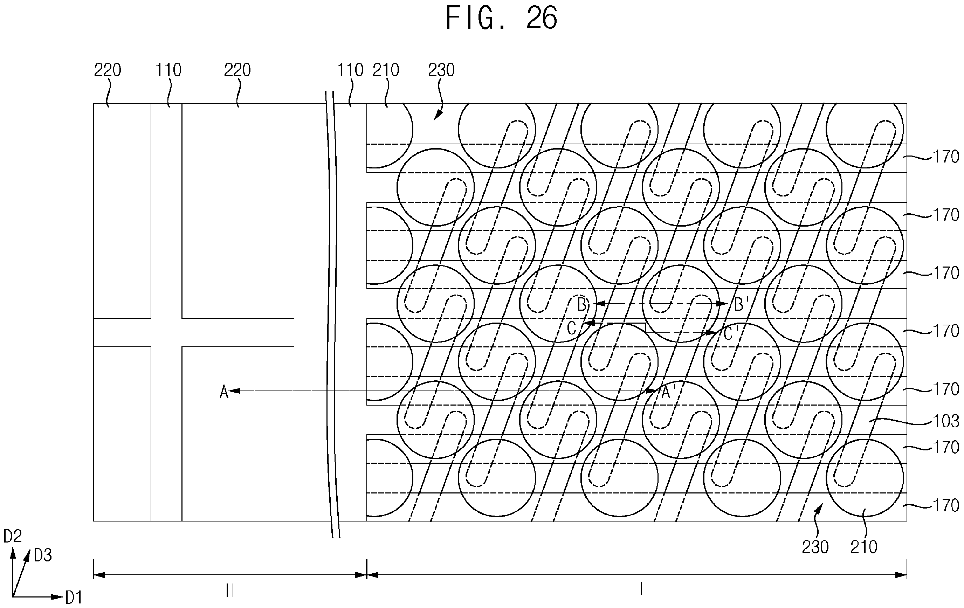

Referring to FIGS. 26 to 28, an insulation layer structure 210 may be formed on the first and second regions I and II of the first substrate 100. A portion of the insulation layer structure 210 on the second region II of the first substrate 100 may be removed, and a thermal oxidation process may be performed on the second active pattern 105 on the second region II of the first substrate 100 to form a second gate insulation layer 220.

The insulation layer structure 210 may include first to third insulation layers 180, 190 and 200 that are sequentially stacked. The first and third insulation layers 180 and 200 may include an oxide, e.g., silicon oxide, and the second insulation layer 190 may include a nitride, e.g., silicon nitride.

Alternatively, the second and third insulation layers 190 and 200 on the second region II of the first substrate 100 among the insulation layer structure 210 may be removed, and the first insulation layer 180 remaining on the second region II of the first substrate 100 may serve as a second gate insulation layer 220. In this embodiment, the second gate insulation layer 220 may be formed not only on the second active pattern 105 but also on the isolation pattern structure 110 on the second region II of the first substrate 100.

The insulation layer structure 210 may be patterned, and the first active pattern 103, the isolation pattern structure 110, and the first gate mask 160 of the first gate structure 170 may be partially etched using the patterned insulation layer structure 210 as an etching mask to form a first opening 230. In example embodiments, the patterned insulation layer structure 210 may have a shape of a circle or an ellipse in a plan view, and a plurality of insulation layer structures 210 may be spaced apart from each other in the first and second directions D1 and D2 on the first region I of the first substrate 100. Each of the insulation layer structures 210 may overlap opposite end portions in the third direction D3 of the first active patterns 103 in the vertical direction.

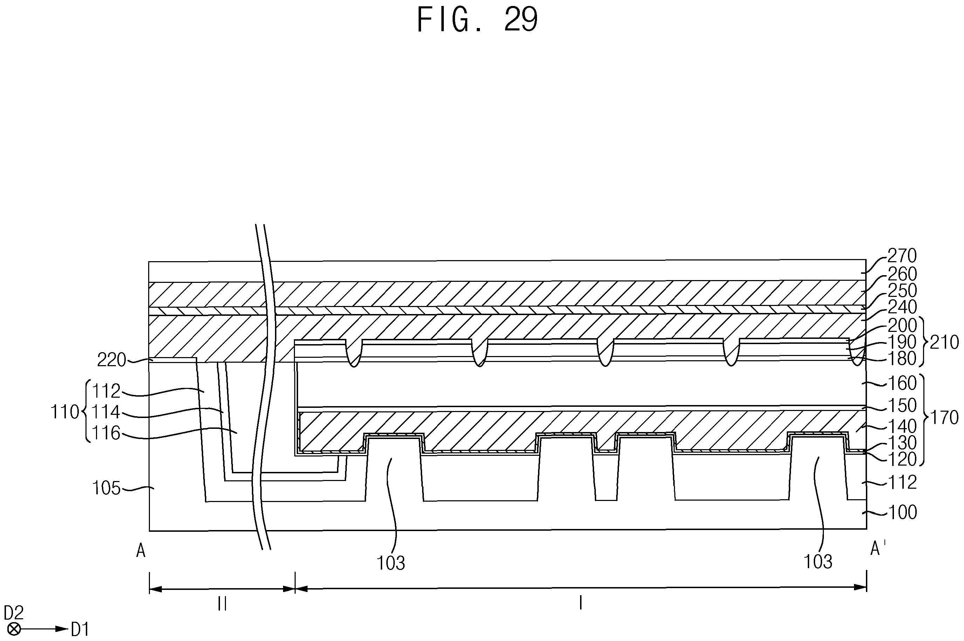

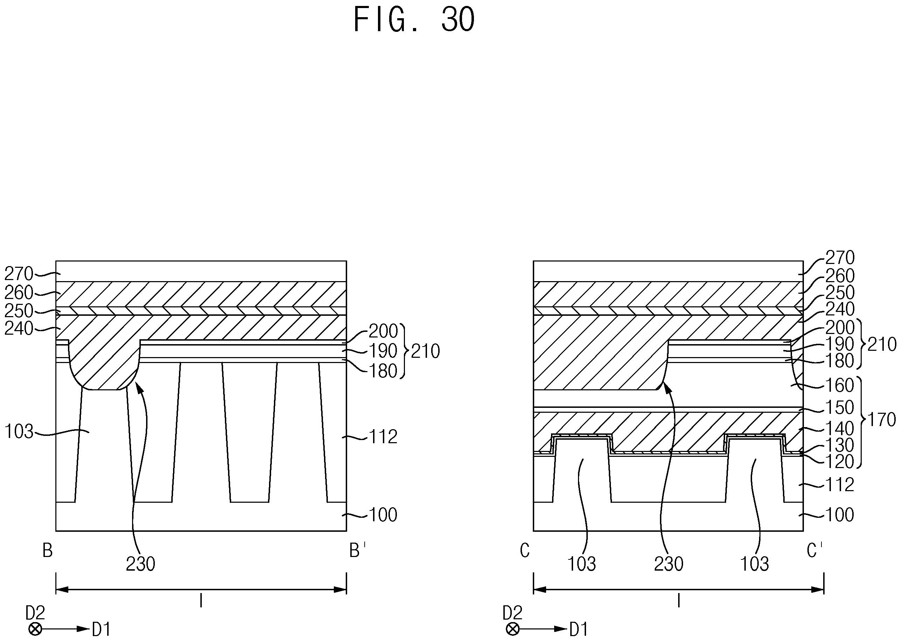

Referring to FIGS. 29 and 30, a third conductive layer 240, a second barrier layer 250, a fourth conductive layer 260 and a first mask layer 270 may be sequentially stacked on the insulation layer structure 210, the first active pattern 103, the isolation pattern structure 110 and the first gate structure 170 exposed by the first opening 230 on the first region I of the first substrate 100, and the second gate insulation layer 220 and the isolation pattern structure 110 on the second region II of the first substrate 100, which may form a conductive structure layer. The third conductive layer 240 may fill or be in the first opening 230.

The third conductive layer 240 may include doped polysilicon, the second barrier layer 250 may include a metal silicon nitride, e.g., titanium silicon nitride, the fourth conductive layer 260 may include a metal, e.g., tungsten, and the first mask layer 270 may include a nitride, e.g., silicon nitride.

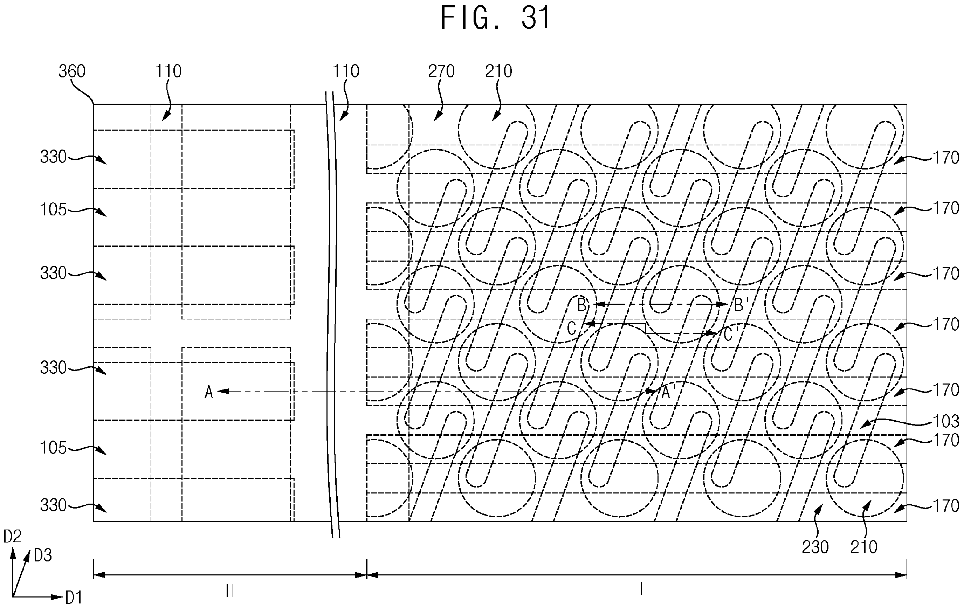

Referring to FIGS. 31 to 33, the conductive structure layer and the second gate insulation layer 220 may be patterned to form a second gate structure 330 on the second region II of the first substrate 100.

The second gate structure 330 may include a second gate insulation pattern 280, a third conductive pattern 290, a second barrier pattern 300, a fourth conductive pattern 310 and a second gate mask 320 sequentially stacked in the vertical direction, and the third conductive pattern 290, the second barrier pattern 300 and the fourth conductive pattern 310 may form a second gate electrode.

The second gate structure 330 may partially overlap the second active pattern 105 in the vertical direction on the second region II of the first substrate 100. FIG. 31 shows four second gate structures 330, each of which may extend in the first direction D1 and are spaced apart from each other in the second direction D2. However, the present disclosure may not be limited thereto.

A portion of the conductive structure layer on an edge portion of the first region I of the first substrate 100 adjacent to the second region II of the first substrate 100 may also be removed, and thus the insulation layer structure 210, upper surfaces of the first active pattern 103, the isolation pattern structure 110 and the first gate structure 170 exposed by the first opening 230 may also be partially exposed.

A first gate spacer structure may be formed on a sidewall of the second gate structure 330, and a second gate spacer structure may be formed on a sidewall of the conductive structure layer remaining on the first region I of the first substrate 100. The first gate spacer structure may include first and third spacers 340 and 350 stacked on the sidewall of the second gate structure 330 in a horizontal direction substantially parallel to the upper surface of the first substrate 100, and the second gate spacer structure may include second and fourth spacers 345 and 355 stacked on the sidewall of the conductive structure layer in the horizontal direction.

The first and second spacers 340 and 345 may be formed by forming a first spacer layer on the first substrate 100 to cover or overlap the conductive structure layer and the second gate structure 330 and anisotropically etching the first spacer layer. The third and fourth spacers 350 and 355 may be formed by forming a second spacer layer on the first substrate 100 to cover or overlap the conductive structure layer, the second gate structure 330 and the first and second spacers 340 and 345 and anisotropically etching the second spacer layer.

The first and second spacers 340 and 345 may include a nitride, e.g., silicon nitride, and the third and fourth spacers 350 and 355 may include an oxide, e.g., silicon oxide.

However, the structure of the first and second gate spacer structures may not be limited thereto, and each of the first and second gate spacer structures may include a single spacer or more than two spacers sequentially stacked.

In example embodiments, impurities may be implanted into upper portions of the second active pattern 105 adjacent to the second gate structure 330 to form source/drain layers, and the second gate structure 330 and the source/drain layers may form a transistor. However, impurities may not be implanted into an upper portion of the second active pattern 105 adjacent to one or ones of the second gate structures 330, which may be a dummy gate structure not operating as a gate of a transistor. FIG. 31 shows only the dummy gate structure.

A first etch stop layer 360 may be formed on the first substrate 100 to cover or overlap the conductive structure layer, the second gate structure 330, the first and second gate spacer structures, and the isolation pattern structure 110. The first etch stop layer 360 may include a nitride, e.g., silicon nitride.

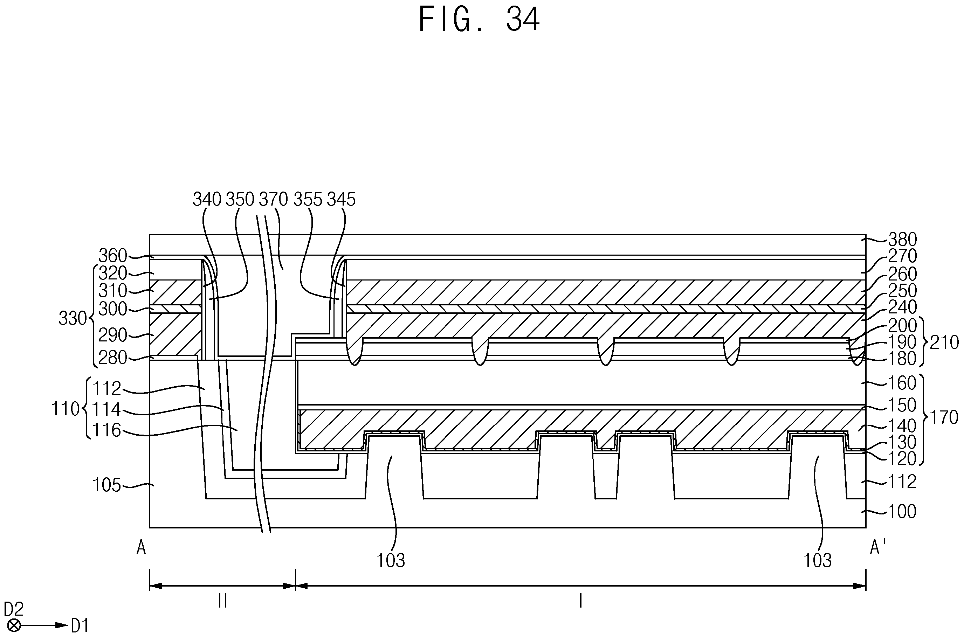

Referring to FIG. 34, a fourth insulating interlayer 370 may be formed on the first etch stop layer 360 to have a sufficient height, and may be planarized until an upper surface of the second gate structure 330 and an upper surface of a portion of the first etch stop layer 360 on the conductive structure layer are exposed.

Thus, the fourth insulating interlayer 370 may fill or be in a space between the first gate spacer structures on the sidewalls of the second gate structures 330, and a space between the first gate spacer structure on the sidewall of the second gate structure 330 and the second gate spacer structure on the sidewall of the conductive structure layer.

The fourth insulating interlayer 370 may include an oxide, e.g., silicon oxide, and a first capping layer 380 may include a nitride, e.g., silicon nitride.

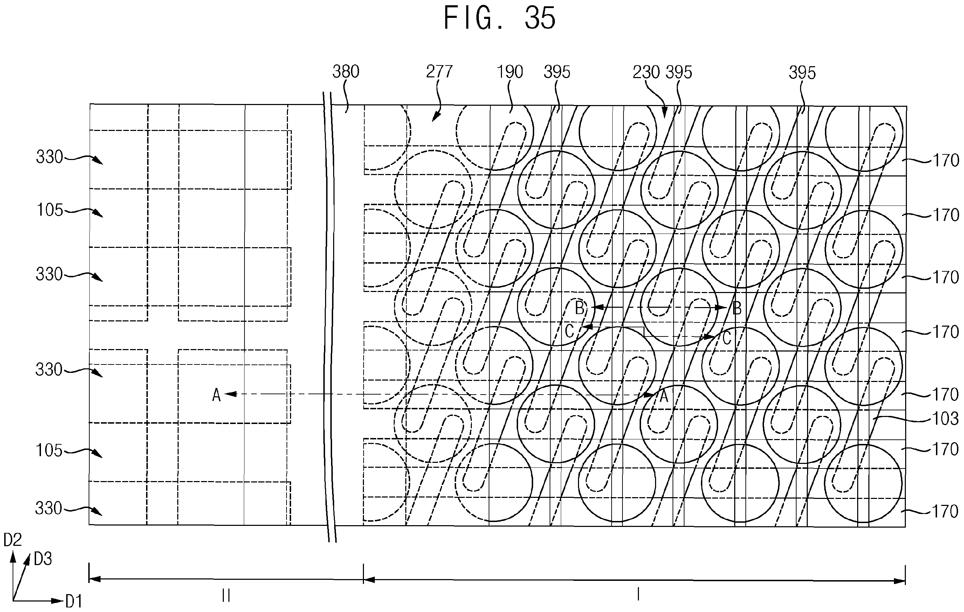

Referring to FIGS. 35 to 37, a portion of the first capping layer 380 on the first region I of the first substrate 100 may be etched to form a first capping pattern 385, and the first etch stop layer 360, the first mask layer 270, the fourth conductive layer 260, the second barrier layer 250 and the third conductive layer 240 may be sequentially etched using the first capping pattern 385 as an etching mask.

In example embodiments, the first capping pattern 385 may extend in the second direction D2 on the first region I of the first substrate 100, and a plurality of first capping patterns 385 may be formed to be spaced apart from each other in the first direction D1. The first capping layer 380 may remain on the second region II of the first substrate 100.

By the etching process, on the first region I of the first substrate 100, a fifth conductive pattern 245, a third barrier pattern 255, a sixth conductive pattern 265, a first mask 275, a first etch stop pattern 365 and the first capping pattern 385 may be sequentially stacked on the first opening 230. A third insulation pattern 205, the fifth conductive pattern 245, the third barrier pattern 255, the sixth conductive pattern 265, the first mask 275, the first etch stop pattern 365 and the first capping pattern 385 may be sequentially stacked on the second insulation layer 190 of the insulation layer structure 210 at an outside of the first opening 230.

Hereinafter, the fifth conductive pattern 245, the third barrier pattern 255, the sixth conductive pattern 265, the first mask 275, the first etch stop pattern 365 and the first capping pattern 385 sequentially stacked may be referred to as a bit line structure 395. The fifth conductive pattern 245, the third barrier pattern 255 and the sixth conductive pattern 265 sequentially stacked may collectively form a conductive structure, and the first mask 275, the first etch stop pattern 365 and the first capping pattern 385 sequentially stacked may collectively form an insulation structure. In example embodiments, the bit line structure 395 may extend in the second direction D2 on the first region I of the first substrate 100, and a plurality of bit line structures 395 may be spaced apart from each other in the first direction D1.

A dummy bit line structure including a seventh conductive pattern 247, a fourth barrier pattern 257, an eighth conductive pattern 267 and a second mask 277 sequentially stacked and extending in the second direction D2 may be formed on a portion of the first region I of the first substrate 100 adjacent to the second region II of the first substrate 100 in the first direction D1, and the first etch stop layer 360 may remain on the second gate structure 330, the dummy bit line structure, the first and second gate spacer structures, a portion of the insulation layer structure 210, and the isolation pattern structure 110. Additionally, the first capping layer 380 may remain on portions of the first etch stop layer 360 on upper surfaces of the second gate structure 330 and the dummy bit line structure and the fourth insulating interlayer 370.

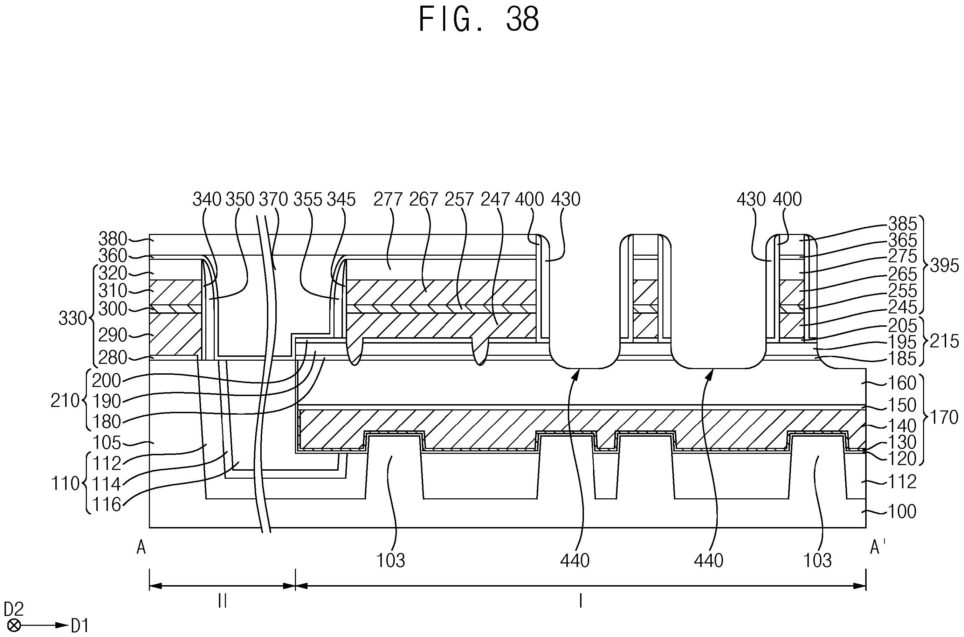

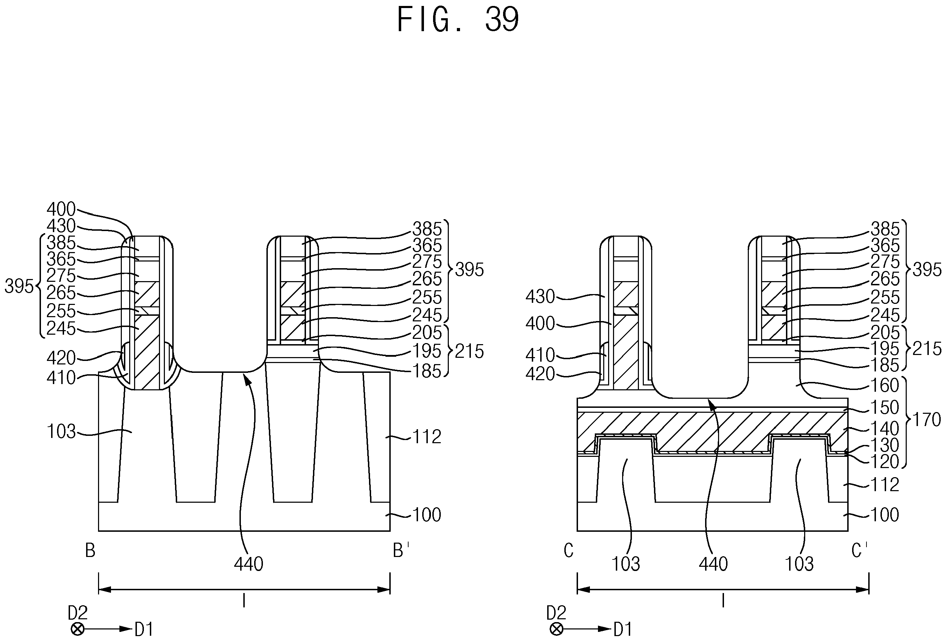

Referring to FIGS. 38 and 39, a fifth spacer layer may be formed on the first substrate 100 to cover or overlap the bit line structure 395, the dummy bit line structure and the first capping layer 380, and fourth and fifth insulation layers may be sequentially formed on the fifth spacer layer.

The fifth spacer layer may also cover or overlap a sidewall of the third insulation pattern 205 between the second insulation layer 190 and the bit line structure 395, and the fifth insulation layer may fill the first opening 230.

The fifth spacer layer may include a nitride, e.g., silicon nitride, the fourth insulation layer may include an oxide, e.g., silicon oxide, and the fifth insulation layer may include a nitride, e.g., silicon nitride.

The fourth and fifth insulation layers may be etched by an etching process. In example embodiments, the etching process may be performed by a wet etch process using an etching solution including phosphorous acid (H₃PO₄), SC1, hydrogen fluoride (HF), and other portions of the fourth and fifth insulation layers except for a portion in the first opening 230 may be removed. Thus, most of an entire surface of the fifth spacer layer, that is, an entire surface except for a portion thereof in the first opening 230, may be exposed, and portions of the fourth and fifth insulation layers remaining in the first opening 230 may form fourth and fifth insulation patterns 410 and 420, respectively.

A sixth spacer layer may be formed on the exposed surface of the fifth spacer layer and the fourth and fifth insulation patterns 410 and 420 in the first opening 230, and may be anisotropically etched to form a sixth spacer 430 on the surface of the fifth spacer layer and the fourth and fifth insulation patterns 410 and 420 to cover or overlap a sidewall of the bit line structure 395. The sixth spacer layer may also be formed on a sidewall of the dummy bit line structure. The sixth spacer layer may include an oxide, e.g., silicon oxide.

A dry etching process may be performed using the first capping pattern 385 and the sixth spacer 430 as an etching mask to form a second opening 440 exposing the upper surface of the first active pattern 103. An upper surface of the first isolation pattern 112 of the isolation pattern structure 110 and an upper surface of the first gate mask 160 may also be exposed by the second opening 440.

By the dry etching process, portions of the fifth spacer layer on upper surfaces of the first capping pattern 385, the second insulation layer 190 and the first capping layer may be removed, and thus a fifth spacer 400 covering or overlapping the sidewall of the bit line structure 395 may be formed. The fifth spacer 400 may also cover or overlap the sidewall of the dummy bit line structure.

Additionally, during the dry etching process, the first and second insulation layers 180 and 190 may be partially removed such that first and second insulation patterns 185 and 195 remain under the bit line structure 395. The first to third insulation patterns 185, 195 and 205 that are sequentially stacked under the bit line structure 395 may form an insulation pattern structure 215.

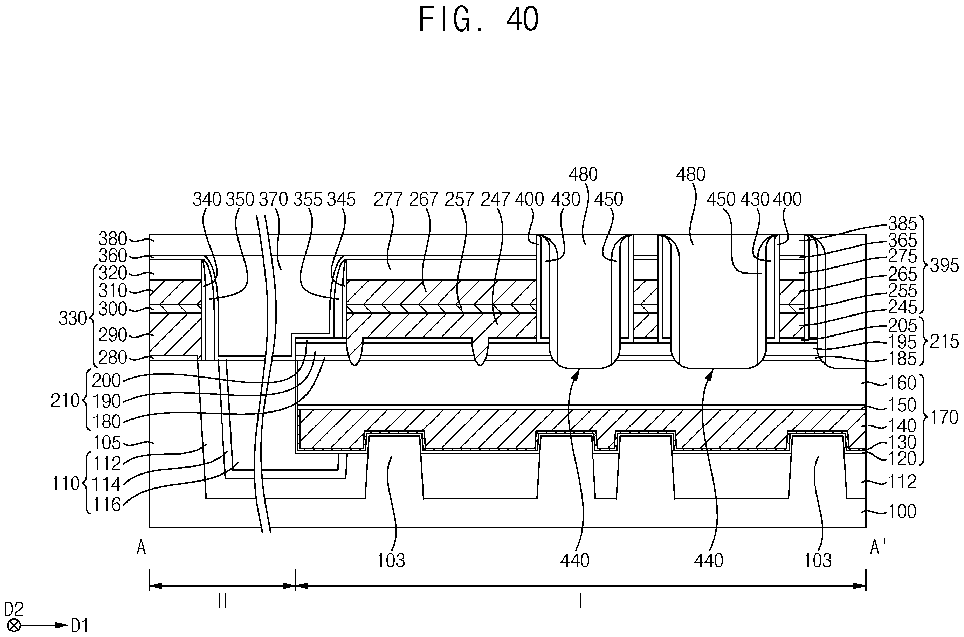

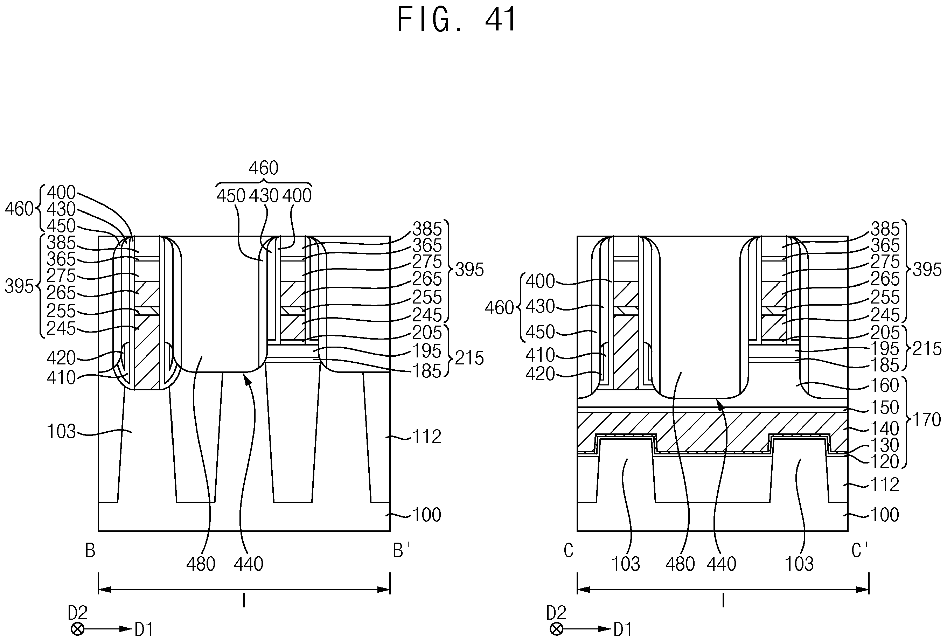

Referring to FIGS. 40 and 41, a seventh spacer layer may be formed on the upper surface of the first capping pattern 385, the upper surface of the first capping layer 380, an outer sidewall of the sixth spacer 430, portions of upper surfaces of the fourth and fifth insulation patterns 410 and 420, the upper surfaces of the first active pattern 103, the first isolation pattern 112 and the first gate mask 160 exposed by the second opening 440. The seventh spacer layer may be anisotropically etched to form a seventh spacer 450 covering or overlapping the sidewall of the bit line structure 395. The seventh spacer layer may include a nitride, e.g., silicon nitride.

The fifth to seventh spacers 400, 430 and 450 sequentially stacked in the horizontal direction from the sidewall of the bit line structure 395 on the first region I of the first substrate 100 may be referred to as a bit line spacer structure 460.

A second capping pattern 480 may be formed on the first region I of the first substrate 100 to fill or be in the second opening 440, and may be planarized until the upper surfaces of the first capping pattern 385 and the first capping layer 380 are exposed.

In example embodiments, the second capping pattern 480 may extend in the second direction D2, and a plurality of second capping patterns 480 may be spaced apart from each other in the first direction D1 by the bit line structures 395. The second capping pattern 480 may include, for example, doped polysilicon.

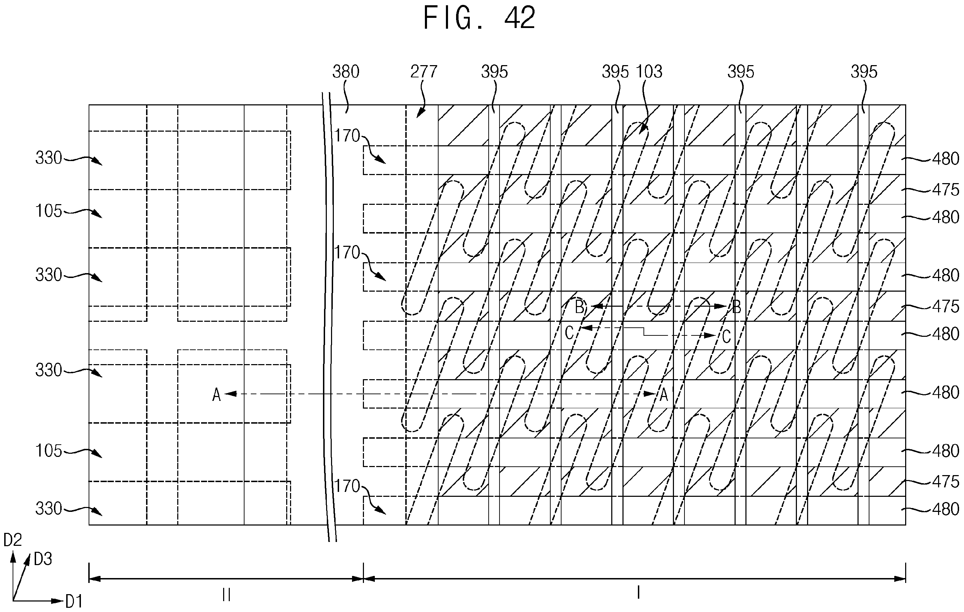

Referring to FIGS. 42 to 44, a third mask having third openings, each of which may extend in the first direction D1 on the first region I of the first substrate 100 and are spaced apart from each other in the second direction D2, may be formed on the first capping pattern 385, the first capping layer 380 and the second capping pattern 480. An etching process may be performed on the second capping pattern 480 using the third mask as an etching mask.

In example embodiments, each of the third openings may overlap an area between the first gate structures 170 on the first region I of the first substrate 100 in the vertical direction. As the etching process is performed, a fourth opening may be formed to expose an upper surface of the first active pattern 103 between the bit line structures 395 on the first region I of the first substrate 100.

After removing the third mask, a lower contact plug 475 may be formed on the first region I of the first substrate 100 to fill or be in the fourth opening. The lower contact plug 475 may include, for example, doped polysilicon. In example embodiments, the lower contact plug 475 may extend in the first direction D1 between the bit line structures 395, and a plurality of lower contact plugs 475 may be spaced apart from each other in the second direction D2 by the second capping patterns 480.

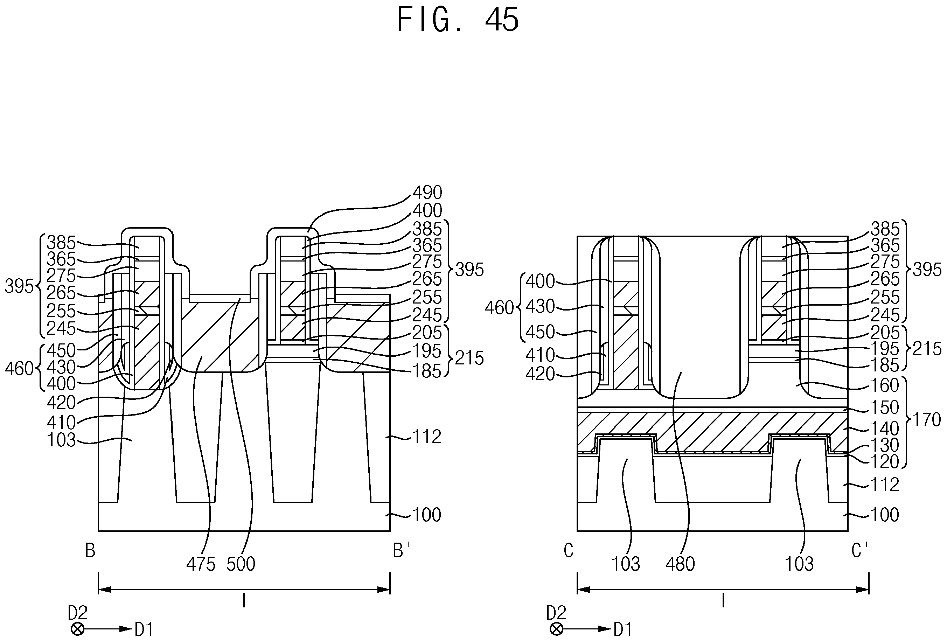

Referring to FIG. 45, an upper portion of the lower contact plug 475 may be removed to expose an upper portion of the bit line spacer structure 460 on the sidewall of the bit line structure 395, and upper portions of the sixth and seventh spacers 430 and 450 of the exposed bit line spacer structure 460 may be removed.

An etch back process may be further performed to remove an upper portion of the lower contact plug 475. Thus, an upper surface of the lower contact plug 475 may be lower than uppermost surfaces of the sixth and seventh spacers 430 and 450 (e.g., a distance between the first substrate 100 and the lower contact plug 475 is less than a distances between uppermost surfaces of the sixth spacer 430 and the first substrate and uppermost surfaces of the seventh spacer 450 and the first substrate 100).

An eighth spacer layer may be formed on the bit line structure 395, the bit line spacer structure 460, the second capping pattern 480, the first capping layer 380, and the lower contact plug 475. The eight spacer layer may be anisotropically etched so that an eighth spacer 490 may be formed to cover or overlap an upper portion of the bit line spacer structure 460 on each of opposite sidewalls of the bit line structure 395 in the first direction D1 and such that an upper surface of the lower contact plug 475 is exposed and not covered or overlapped by the eighth spacer 490.

A metal silicide pattern 500 may be formed on the exposed upper surface of the lower contact plug 475. In example embodiments, the metal silicide patterns 500 may be formed by forming a metal layer on the first and second capping patterns 385 and 480, the first capping layer 380, the eighth spacer 490, and the lower contact plug 475, thermally treating the metal layer, and removing an unreacted portion of the metal layer. The metal silicide patterns 500 may include, for example, cobalt silicide, nickel silicide, titanium silicide, etc.

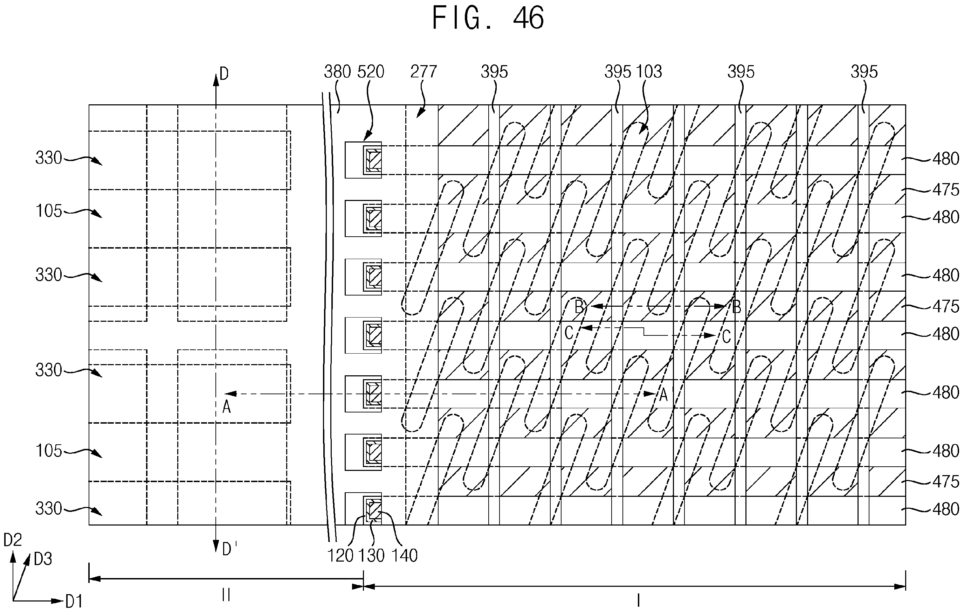

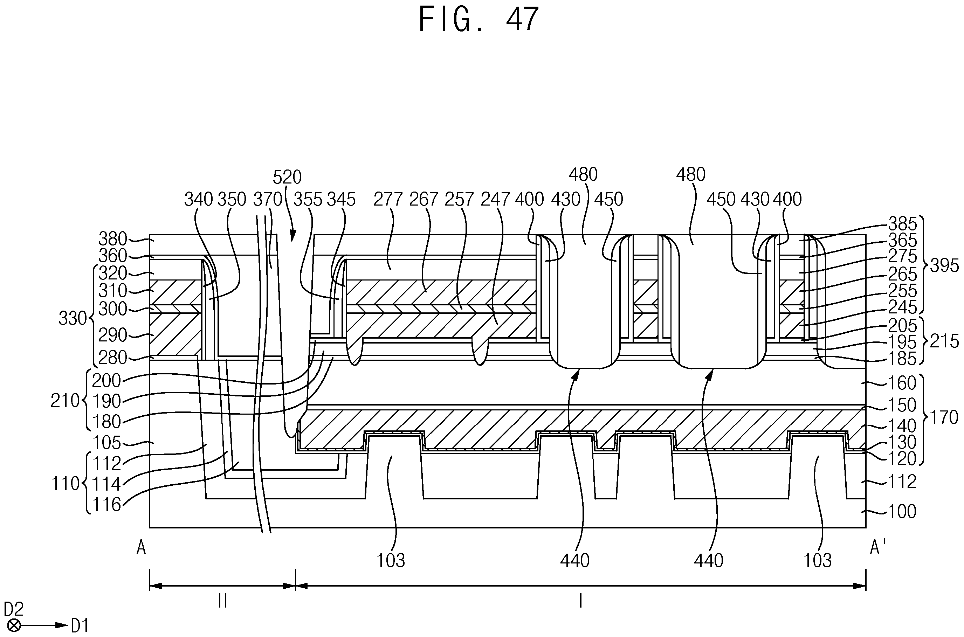

Referring to FIGS. 46 and 47, a first sacrificial layer may be formed on the first and second capping patterns 385 and 480, the eighth spacer 490, the metal silicide pattern 500 and the lower contact plug 475, and an upper portion of the first sacrificial layer may be planarized until upper surfaces of the first and second capping patterns 385 and 480 and the first capping layer 380 are exposed.

The first sacrificial layer may include, for example, SOH, ACL, etc.

A fifth opening 520 may be formed to extend through a portion of the first capping layer 380 at a boundary between the first and second regions I and II of the first substrate 100. The fifth opening 520 may extend through the fourth insulating interlayer 370, the first etch stop layer 360, the insulation layer structure 210, the first gate mask 160, the second conductive pattern 150 and the isolation pattern structure 110 under the portion of the first capping layer 380 to expose the first conductive pattern 140. The fifth opening 520 may also expose the first barrier pattern 130 and the first gate insulation pattern 120 on the sidewall of the first conductive pattern 140.

Additionally, a sixth opening (not shown) may also be formed to extend through a portion of the first capping layer 380 on the second region II of the first substrate 100, the fourth insulating interlayer 370 under the portion of the first capping layer 380, and the first etch stop layer 360 to expose an upper surface of the second active pattern 105 between the second gate structures 330. However, the sixth opening may expose an upper surface of the source/drain layer at an upper portion of the second active pattern 105 between the second gate structures 330 operating as a gate of a transistor, and may not be formed between the second gate structures 330, which may be dummy gate structures.

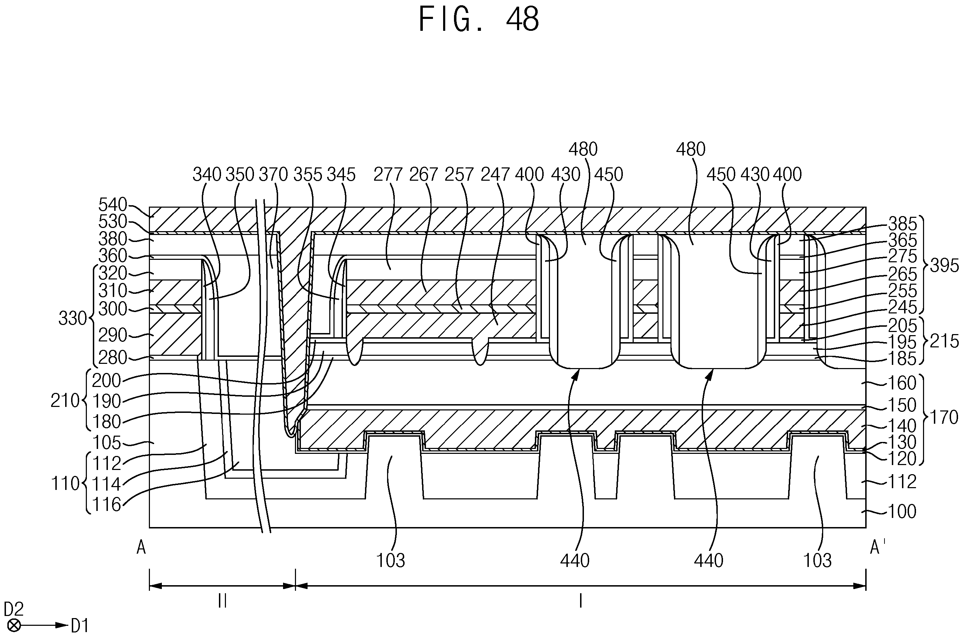

Referring to FIGS. 48 to 50, the first sacrificial layer may be removed by, e.g., an ashing process and/or a stripping process, and a fifth barrier layer 530 may be formed on the first and second capping patterns 385 and 480, the eighth spacer 490, the metal silicide pattern 500 and the lower contact plug 475 on the first region I of the first substrate 100. The fifth barrier layer 530 may also be on the first capping layer 380, a sidewall of the fifth opening 520, the first conductive pattern 140, the first barrier pattern 130, the first gate insulation pattern 120 and the isolation pattern structure 110 exposed by the fifth opening 520, and the source/drain layer exposed by the sixth opening. A second metal layer 540 may be formed on the fifth barrier layer 530 to fill or be in a space between the bit line structures 395, the fifth opening 520 and the sixth opening.

The fifth barrier layer 530 may include a metal nitride, e.g., titanium nitride, tantalum nitride, etc., and the second metal layer 540 may include a metal, e.g., tungsten.

A planarization process may be further performed on an upper portion of the second metal layer 540. The planarization process may include a CMP process and/or an etch back process.

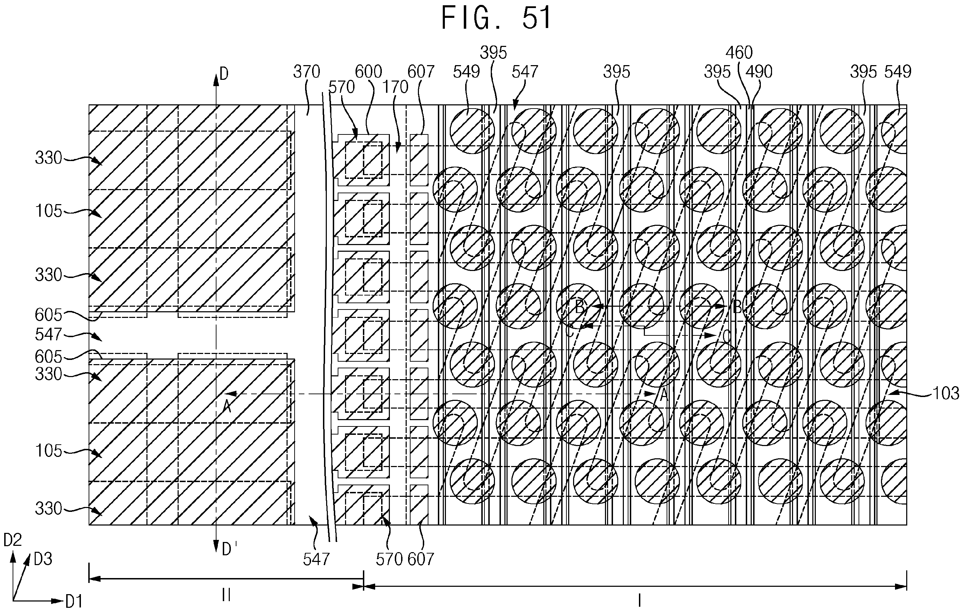

Referring to FIGS. 51 to 54, the second metal layer 540 and the fifth barrier layer 530 may be patterned.

Thus, an upper contact plug 549 may be formed on the first region I of the first substrate 100, a fifth wiring 600 may be formed on the boundary between the first and second regions I and II of the first substrate 100, a first conductive pad 605 may be formed on the second region II of the first substrate 100, and a second conductive pad 607 may be formed on a portion of the first region I adjacent to the second region II of the first substrate 100 in the first direction D1. A seventh opening 547 may be formed between the upper contact plug 549, the first wiring 600, and the first and second conductive pads 605 and 607. An upper portion of the upper contact plug 549 may operate as a landing pad of a cell capacitor structure that may be subsequently formed.

The seventh opening 547 may be formed by removing not only the second metal layer 540 and the fifth barrier layer 530 but also the first and second capping patterns 385 and 480, the first capping layer 380, the bit line spacer structure 460, the eighth spacer 490, the first etch stop layer 360, the first etch stop pattern 365, the first mask 275, the second gate mask 320, and the first and second gate spacer structures.

As the seventh opening 547 is formed, the second metal layer 540 and the fifth barrier layer 530 may be transformed into a first metal pattern 545 and a fifth barrier pattern 535, respectively, covering or overlapping a lower surface of the first metal pattern 545, which may form an upper contact plug 549 on the first region I of the first substrate 100. In example embodiments, a plurality of upper contact plugs 549 may be formed to be spaced apart from each other in each of the first and second directions D1 and D2, and may be arranged in a honeycomb pattern or a lattice pattern in a plan view. Each of the upper contact plugs 549 may have a shape of a circle, an ellipse, or a polygon in a plan view.

The lower contact plug 475, the metal silicide pattern 500 and the upper contact plug 549 sequentially stacked on the first region I of the first substrate 100 may form a contact plug structure.

The fifth wiring 600 may include a fourth metal pattern 590 and an eighth barrier pattern 580 covering or overlapping a lower surface of the fourth metal pattern 590, and the first conductive pad 605 may include a fifth metal pattern 595 and a ninth barrier pattern 585 covering or overlapping a lower surface of the fifth metal pattern 595. A seventh contact plug 570 including a second metal pattern 560 and a sixth barrier pattern 550 may be formed in the fifth opening 520, and an eighth contact plug including a third metal pattern and a seventh barrier pattern may be formed in the sixth opening. The second conductive pad 607 may include a sixth metal pattern 597 and a tenth barrier pattern 587 covering or overlapping a lower surface of the sixth metal pattern 597.

In example embodiments, the fifth wiring 600 may extend from the boundary between the first and second regions I and II of the first substrate 100 toward the second region II of the first substrate 100 in the first direction D1, and a plurality of fifth wirings 600 may be spaced apart from each other in the second direction D2. In example embodiments, the fifth wiring 600 may overlap the fifth opening 520 in the vertical direction, and at least one of the fifth wirings 600 may overlap the sixth opening in the vertical direction.

Thus, the fifth wiring 600 may be connected to the first conductive pattern 140 through the seventh contact plug 570, and may apply electrical signals to the first gate structure 170. Additionally, the fifth wiring 600 may be connected to the source/drain layer at the upper portion of the second active pattern 105 through the eighth contact plug, and may apply electrical signals to the source/drain layer.

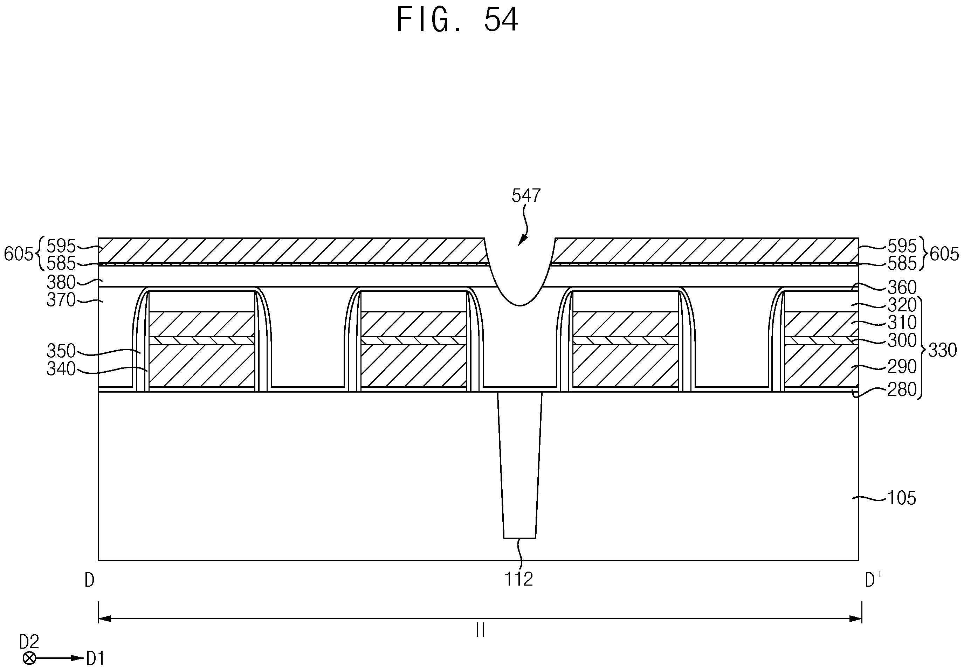

In example embodiments, two neighboring or adjacent first conductive pads 605 on a portion of the second region II of the first substrate 100 may form a pair of first conductive pads 605, and a plurality of pairs of first conductive pads 605 may be spaced apart from each other in each of the first and second directions D 1 and D2. FIG. 54 shows one pair of first conductive pads 605 spaced apart from each other in the first direction D 1 by the seventh opening 547 extending in the second direction D2, however, the present disclosure may not be limited thereto.

The second conductive pad 607 may overlap the dummy bit line structure in the vertical direction.

In some embodiments, the exposed sixth spacer 430 may be removed to form an air gap connected to the seventh opening 547. The sixth spacer 430 may be removed by, e.g., a wet etching process.

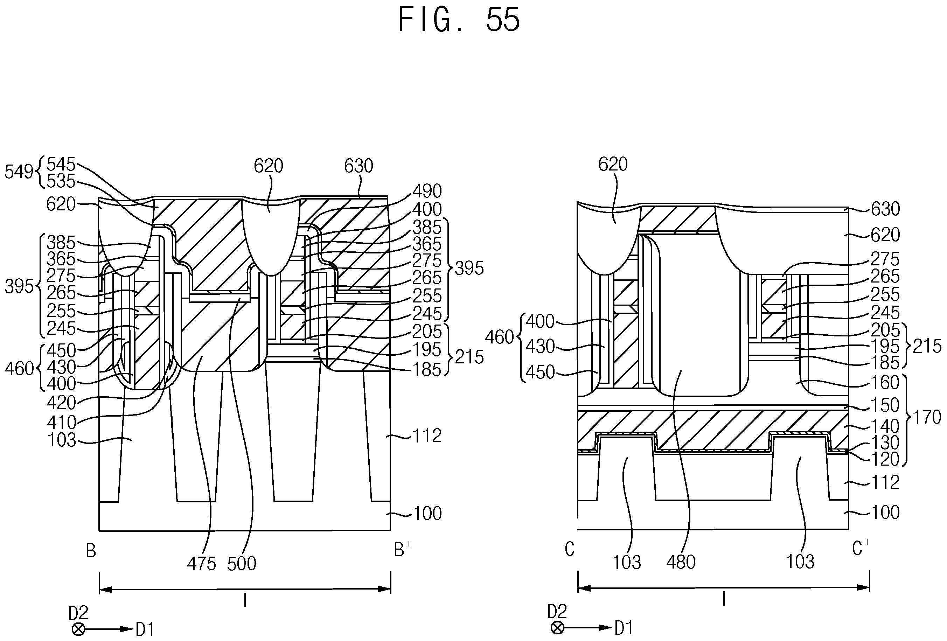

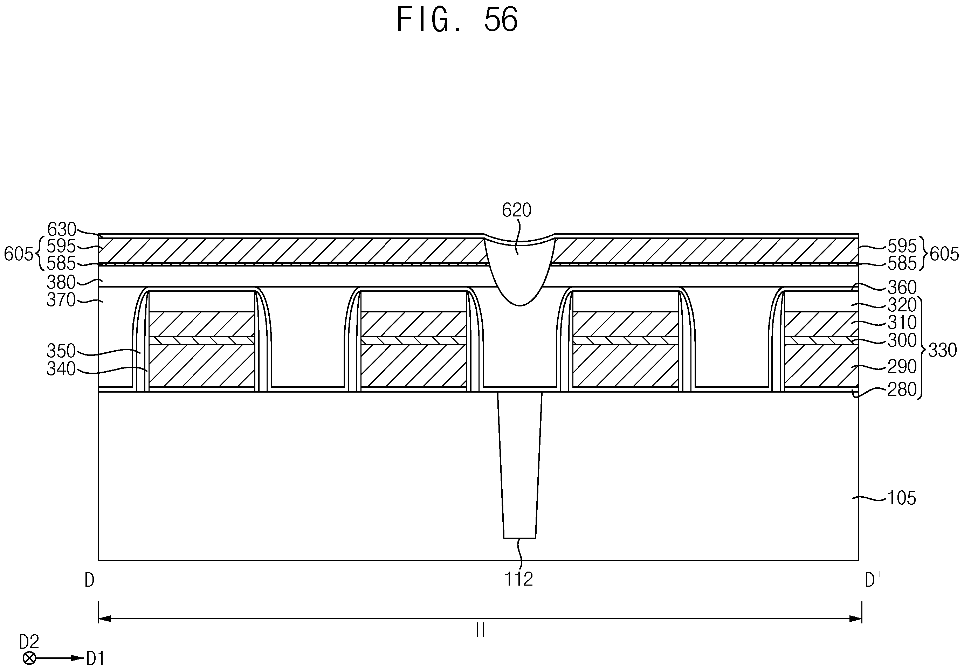

Referring to FIGS. 55 and 56, a sixth insulation layer 620 may be formed to fill or be in the seventh opening 547, and a second etch stop layer 630 may be formed on the sixth insulation layer 620, the upper contact plug 549, the fifth wiring 600 and the first and second conductive pads 605 and 607.

The sixth insulation layer 620 may include a nitride, e.g., silicon nitride, and the second etch stop layer 630 may include a nitride, e.g., silicon boronitride, silicon carbonitride, etc.

If the air gap connected with the seventh opening 547 is formed, the sixth insulation layer 620 may be formed to include a material having a low gap filling characteristic, and thus the air gap may not be filled with or include the sixth insulation layer 620 but remain. The air gap may be referred to as an air spacer.

Referring to FIGS. 57 to 60, a mold layer may be formed on the second etch stop layer 630, and a portion of the mold layer and a portion of the second etch stop layer 630 thereunder may be etched to form eighth and ninth openings partially exposing the upper contact plug 549 and the first conductive pad 605, respectively.

As the plurality of upper contact plugs 549 are spaced apart from each other in each of the first and second directions D1 and D2 in a honeycomb pattern or a lattice pattern in a plan view, a plurality of eighth openings exposing the plurality of upper contact plugs 549, respectively, may be spaced apart from other in each of the first and second directions D1 and D2 in a honeycomb pattern or a lattice pattern in a plan view.

In example embodiments, the ninth openings may be arranged in honeycomb pattern or a lattice pattern on each of the first conductive pads 605 in a plan view. Each of the ninth openings may have a shape of, for example, a circle, an ellipse or a polygon.

A first capacitor electrode layer may be formed on sidewalls of the eighth and ninth openings, the upper surfaces of the upper contact plug 549 and the first conductive pad 605 and the mold layer. A second sacrificial layer may be formed on the first capacitor electrode layer to fill or be in remaining portions of the eighth and ninth openings, and the first capacitor electrode layer and the second sacrificial layer may be planarized until an upper surface of the mold layer is exposed to divide the first capacitor electrode layer into a plurality of parts. Thus, first and fourth capacitor electrodes 660 and 665 having a pillar shape may be formed in the eighth and ninth openings, respectively.

The second sacrificial layer and the mold layer may be removed by a wet etching process using an etching solution including, e.g., LAL.

A dielectric layer may be formed on surfaces of the first and fourth capacitor electrodes 660 and 665 and an upper surface of the second etch stop layer 630, and second and third capacitor electrode layers may be sequentially formed on the dielectric layer. The second and third capacitor electrode layers and the dielectric layer may be patterned, and the second etch stop layer 630 may be exposed.

Thus, a cell capacitor structure including a first capacitor electrode 660, a first dielectric pattern 670, a second capacitor electrode 680 and a third capacitor electrode 690 may be formed on the first region I of the first substrate 100, and each of the first capacitor electrodes 660 and corresponding portions of the first dielectric pattern 670, the second capacitor electrode 680 and the third capacitor electrode 690 may collectively form a cell capacitor 700. Accordingly, the first capacitor structure may include a plurality of cell capacitors 700 spaced apart from each other in the first and second directions D1 and D2 on the first region I of the first substrate 100.

Additionally, a first decoupling capacitor structure including a fourth capacitor electrode 665, a second dielectric pattern 675, a fifth capacitor electrode 685 and a sixth capacitor electrode 695 may be formed on the second region II of the first substrate 100, and each of the fourth capacitor electrodes 665 and corresponding portions of the second dielectric pattern 675, the fifth capacitor electrode 685 and the sixth capacitor electrode 695 may collectively form a decoupling capacitor 705. Accordingly, the first decoupling capacitor structure may include a plurality of decoupling capacitors 705 spaced apart from each other in the first and second directions D 1 and D2 on the second region II of the first substrate 100.

In example embodiments, a plurality of first decoupling capacitor structures may be spaced apart from each other on the second region II of the first substrate 100. In example embodiments, a plurality of decoupling capacitors 705 may be formed on each of the first conductive pads 605, and decoupling capacitors 705 on a pair of first conductive pads 605 may share the second dielectric pattern 675, the fifth capacitor electrode 685 and the sixth capacitor electrode 695.

A fifth insulating interlayer 710 may be formed on the cell capacitor structure, the first decoupling capacitor structure and the second etch stop layer 630 on the first and second regions I and II of the first substrate 100. The ninth to eleventh contact plugs 721, 722 and 724 may be formed through the fifth insulating interlayer 710 to contact upper surfaces of a pair of first conductive pads 605. A sixth insulating interlayer 730 may be formed on the fifth insulating interlayer 710 and the ninth to eleventh contact plugs 721, 722 and 724, and sixth to eighth wirings 741, 742 and 744 may be formed through the sixth insulating interlayer 730 to contact upper surfaces of the ninth to eleventh contact plugs 721, 722 and 724, respectively.

The ninth contact plug 721 and the sixth wiring 741 may collectively form a first capacitor connection structure, the tenth contact plug 722 and the seventh wiring 742 may collectively form a second capacitor connection structure, and the eleventh contact plug 724 and the eighth wiring 744 may collectively form a third capacitor connection structure.

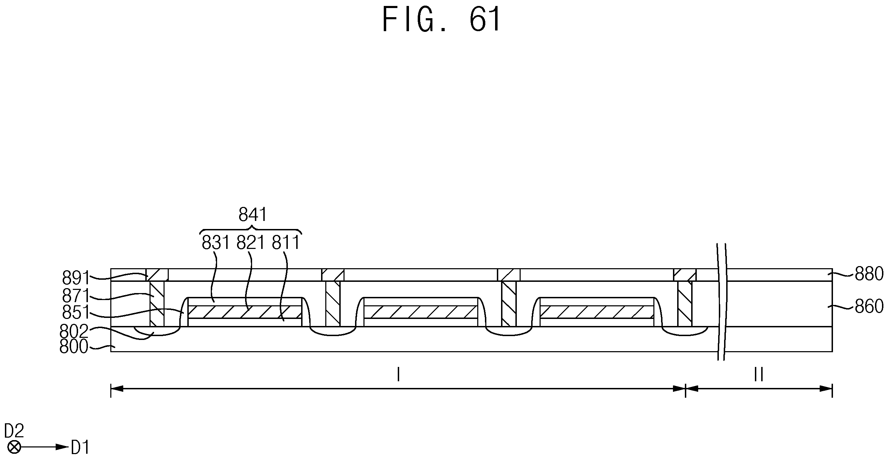

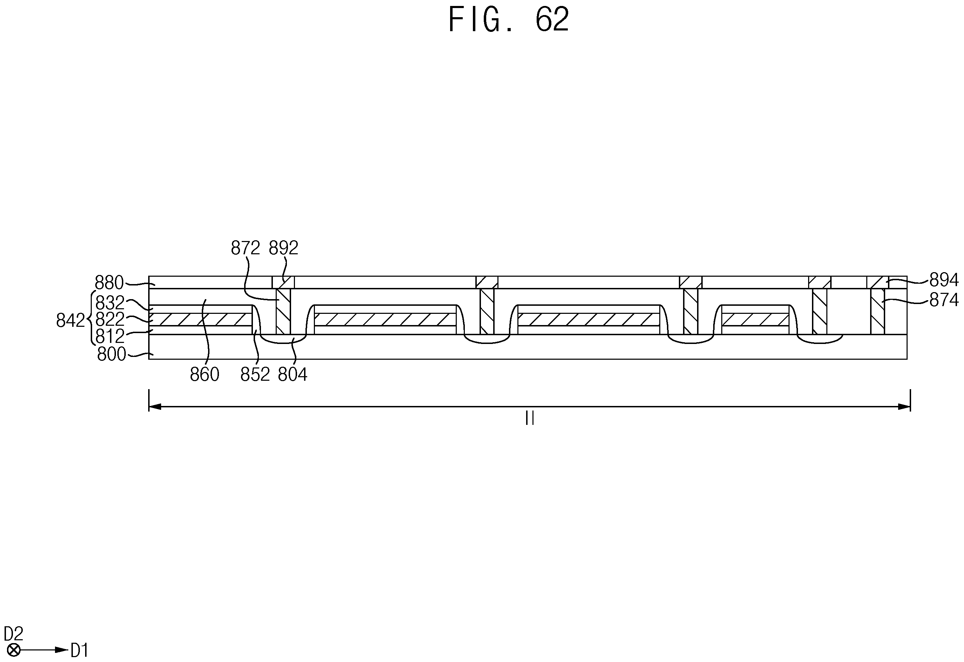

Referring to FIGS. 61 and 62, third and fourth gate structures 841 and 842 may be formed on the first and second regions I and II, respectively, of the second substrate 800. Third and fourth gate spacers 851 and 852 may be formed on sidewalls of the third and fourth gate structures 841 and 842, respectively. First and second source/drain regions 802 and 804 may be formed at upper portions of the first and second regions I and II, respectively, of the second substrate 800 adj acent to the third and fourth gate structures 841 and 842, respectively. A seventh insulating interlayer 860 may be formed on the second substrate 800 to cover or overlap the third and fourth gate structures 841 and 842 and the third and fourth gate spacers 851 and 852.

The third gate structure 841 may include a third gate insulation pattern 811, a third gate electrode 821 and a third gate mask 831 that are sequentially stacked, and the fourth gate structure 842 may include a fourth gate insulation pattern 812, a fourth gate electrode 822 and a fourth gate mask 832 that are sequentially stacked.

Twelfth and thirteenth contact plugs 871 and 872 may be formed through the seventh insulating interlayer 860 to contact upper surfaces of the first and second source/drain regions 802 and 804, respectively, and a fourteenth contact plug 874 may be formed to contact an upper surface of the second region II of the second substrate 800.

An eighth insulating interlayer 880 may be formed on the seventh insulating interlayer 860 and the twelfth to fourteenth contact plugs 871, 872 and 874, and ninth to eleventh wirings 891, 892 and 894 may be formed through the eighth insulating interlayer 880 to contact upper surfaces of the twelfth to fourteenth contact plugs 871, 872 and 874, respectively.

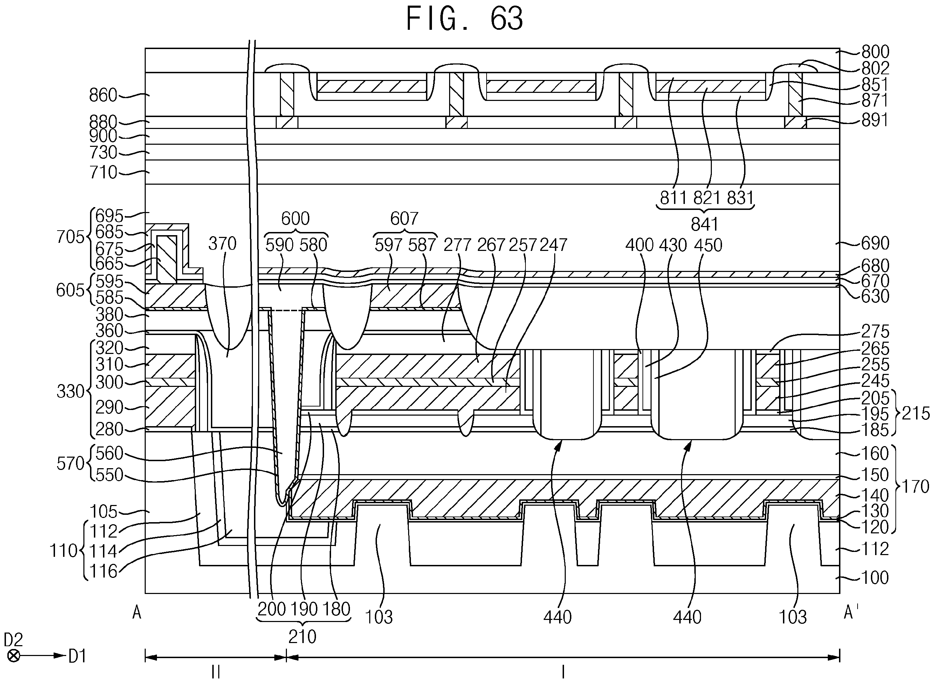

Referring to FIGS. 63 to 65, a bonding layer 900 may be formed on the eighth insulating interlayer 880, and first to third bonding patterns 911, 912 and 914 may be formed through the bonding layer 900 to contact upper surfaces of the ninth to eleventh wirings 891, 892 and 894, respectively.

After flipping the orientation of the second substrate 800, the second substrate 800 may be bonded with the first substrate 100 such that the first to third bonding patterns 911, 912 and 914 may contact upper surfaces of the sixth to eighth wirings 741, 742 and 744, respectively, to complete the fabrication of the semiconductor device.

While the present disclosure has been shown and described with reference to example embodiments thereof, it will be understood by those of ordinary skill in the art that various changes in form and details may be made thereto without departing from the scope of the present disclosure as set forth by the following claims.

Embodiments are set out in the following clauses:
1. A semiconductor device comprising:
   a first gate structure in a cell region of a substrate, wherein the substrate comprises a peripheral circuit region;
   a bit line structure on the cell region of the substrate;
   a cell capacitor structure on the bit line structure;
   a decoupling capacitor structure on the peripheral circuit region of the substrate; and
   a second gate structure on the decoupling capacitor structure.
2. The semiconductor device according to clause 1, further comprising a plurality of second gate structures comprising the second gate structure, wherein the plurality of the second gate structures are spaced apart from each other on the peripheral circuit region of the substrate in a horizontal direction that is substantially parallel to an upper surface of the sub strate.
3. The semiconductor device according to clause 1 or clause 2, further comprising a third gate structure on the cell capacitor structure.
4. The semiconductor device according to any preceding clause, further comprising a plurality of decoupling capacitor structures comprising the decoupling capacitor structure, wherein the plurality of the decoupling capacitors are spaced apart from each other on the peripheral circuit region of the substrate in a horizontal direction that is substantially parallel to an upper surface of the substrate.
5. The semiconductor device according to any preceding clause, further comprising a third gate structure on the peripheral circuit region of the substrate, wherein the third gate structure is spaced apart from the decoupling capacitor structure.
6. The semiconductor device according to any preceding clause, wherein the decoupling capacitor structure comprises:
   first capacitor electrodes that are spaced apart from each other in a horizontal direction that is substantially parallel to an upper surface of the substrate, wherein each of the first capacitor electrodes extends in a vertical direction that is substantially perpendicular to the upper surface of the substrate;
   a dielectric pattern on upper and side surfaces of the first capacitor electrodes;
   a second capacitor electrode on the dielectric pattern; and
   a third capacitor electrode on the second capacitor electrode.
7. The semiconductor device according to clause 6, further comprising a conductive pad that is electrically connected to lower surfaces of the first capacitor electrodes.
8. The semiconductor device according to any preceding clause, wherein the decoupling capacitor structure comprises:
   a first capacitor electrode having a planar shape that extends in a horizontal direction that is substantially parallel to an upper surface of the substrate;
   a second capacitor electrode having the planar shape that extends in the horizontal direction and at least partially overlaps the first capacitor electrode in a vertical direction that is substantially perpendicular to the upper surface of the substrate; and
   a dielectric pattern between the first and second capacitor electrodes.
9. The semiconductor device according to any preceding clause, wherein the decoupling capacitor structure is a first distance from an upper surface of the substrate, wherein the cell capacitor structure is a second distance from the upper surface of the substrate, and wherein the first distance is less than the second distance.
10. The semiconductor device according to any preceding clause, wherein at least a portion of the decoupling capacitor structure is in the substrate.
11. The semiconductor device according to any preceding clause, wherein the decoupling capacitor structure and the cell capacitor structure are separated from an upper surface of the substrate by a substantially same distance.
12. A semiconductor device comprising:
   a first gate structure in a cell region of a first substrate, wherein the first substrate comprises a peripheral circuit region;
   a bit line structure on the cell region of the first substrate;
   a cell capacitor structure on the bit line structure;
   a decoupling capacitor structure at least partially in the peripheral circuit region of the first substrate; and
   a second gate structure on the peripheral circuit region of the first substrate, wherein the second gate structure is a first distance from an upper surface of the first substrate, wherein the cell capacitor structure is a second distance from the upper surface of the first substrate, and wherein the first distance is greater than the second distance.
13. The semiconductor device according to clause 12, further comprising a plurality of second gate structures comprising the second gate structure, wherein the plurality of the second gate structures are spaced apart from each other on the peripheral circuit region of the first substrate in a horizontal direction that is substantially parallel to the upper surface of the first substrate.
14. The semiconductor device according to clause 12 or clause 13, further comprising a third gate structure on the cell capacitor structure.
15. The semiconductor device according to any of clauses 12 to 14, further comprising a second substrate on the first substrate, wherein a lower surface of the second substrate is on the second gate structure.
16. The semiconductor device according to any of clauses 12 to 15, further comprising a second substrate on the first substrate, wherein the second gate structure is on an upper surface of the second substrate.
17. A semiconductor device comprising:
   a first substrate comprising a first cell region and a first peripheral circuit region;
   a first gate structure in the first cell region of the first substrate;
   a bit line structure on the first cell region of the first substrate;
   a cell capacitor structure on the bit line structure;
   a decoupling capacitor structure on the first peripheral circuit region of the first substrate;
   a second substrate on the cell capacitor structure and the decoupling capacitor structure, wherein the second substrate comprises a second cell region and a second peripheral circuit region that correspond to the first cell region of the first substrate and the first peripheral circuit region of the first substrate, respectively;
   a second gate structure on the second cell region of the second substrate;
   a third gate structure on the second peripheral circuit region of the second substrate; and
   through vias that extend into the second substrate, wherein ones of the through vias are electrically connected to the cell capacitor structure and the decoupling capacitor structure.
18. The semiconductor device according to clause 17, further comprising a plurality of third gate structures comprising the third gate structure, wherein the plurality of the third gate structures are spaced apart from each other on the second peripheral circuit region of the second substrate in a horizontal direction that is substantially parallel to an upper surface of the second substrate.
19. The semiconductor device according to clause 17 or clause 18, further comprising a plurality of decoupling capacitor structures comprising the decoupling capacitor structure, wherein the plurality of the decoupling capacitor structures are spaced apart from each other on the first peripheral circuit region of the first substrate in a horizontal direction substantially parallel to an upper surface of the first substrate.
20. The semiconductor device according to any of clauses 17 to 19, further comprising a fourth gate structure on the first peripheral circuit region of the first substrate, wherein the fourth gate structure is spaced apart from the decoupling capacitor structure.

## Claims

1. A semiconductor device comprising:
a first gate structure in a cell region of a substrate, wherein the substrate comprises a peripheral circuit region;
a bit line structure on the cell region of the substrate;
a cell capacitor structure on the bit line structure;
a decoupling capacitor structure on the peripheral circuit region of the substrate; and
a second gate structure on the decoupling capacitor structure.

2. The semiconductor device according to claim 1, further comprising a plurality of second gate structures comprising the second gate structure, wherein the plurality of the second gate structures are spaced apart from each other on the peripheral circuit region of the substrate in a horizontal direction that is substantially parallel to an upper surface of the sub strate.

3. The semiconductor device according to claim 1 or claim 2, further comprising a third gate structure on the cell capacitor structure.

4. The semiconductor device according to any preceding claim, further comprising a plurality of decoupling capacitor structures comprising the decoupling capacitor structure, wherein the plurality of the decoupling capacitors are spaced apart from each other on the peripheral circuit region of the substrate in a horizontal direction that is substantially parallel to an upper surface of the substrate.

5. The semiconductor device according to any preceding claim, further comprising a third gate structure on the peripheral circuit region of the substrate, wherein the third gate structure is spaced apart from the decoupling capacitor structure.

6. The semiconductor device according to any preceding claim, wherein the decoupling capacitor structure comprises:
first capacitor electrodes that are spaced apart from each other in a horizontal direction that is substantially parallel to an upper surface of the substrate, wherein each of the first capacitor electrodes extends in a vertical direction that is substantially perpendicular to the upper surface of the substrate;
a dielectric pattern on upper and side surfaces of the first capacitor electrodes;
a second capacitor electrode on the dielectric pattern; and
a third capacitor electrode on the second capacitor electrode.

7. The semiconductor device according to claim 6, further comprising a conductive pad that is electrically connected to lower surfaces of the first capacitor electrodes.

8. The semiconductor device according to any preceding claim, wherein the decoupling capacitor structure comprises:
a first capacitor electrode having a planar shape that extends in a horizontal direction that is substantially parallel to an upper surface of the substrate;
a second capacitor electrode having the planar shape that extends in the horizontal direction and at least partially overlaps the first capacitor electrode in a vertical direction that is substantially perpendicular to the upper surface of the substrate; and
a dielectric pattern between the first and second capacitor electrodes.

9. The semiconductor device according to any preceding claim, wherein the decoupling capacitor structure is a first distance from an upper surface of the substrate, wherein the cell capacitor structure is a second distance from the upper surface of the substrate, and wherein the first distance is less than the second distance.

10. The semiconductor device according to any preceding claim, wherein at least a portion of the decoupling capacitor structure is in the substrate.

11. The semiconductor device according to any preceding claim, wherein the decoupling capacitor structure and the cell capacitor structure are separated from an upper surface of the substrate by a substantially same distance.

12. A semiconductor device comprising:
a first gate structure in a cell region of a first substrate, wherein the first substrate comprises a peripheral circuit region;
a bit line structure on the cell region of the first substrate;
a cell capacitor structure on the bit line structure;
a decoupling capacitor structure at least partially in the peripheral circuit region of the first substrate; and
a second gate structure on the peripheral circuit region of the first substrate, wherein the second gate structure is a first distance from an upper surface of the first substrate, wherein the cell capacitor structure is a second distance from the upper surface of the first substrate, and wherein the first distance is greater than the second distance.

13. The semiconductor device according to claim 12, further comprising a plurality of second gate structures comprising the second gate structure, wherein the plurality of the second gate structures are spaced apart from each other on the peripheral circuit region of the first substrate in a horizontal direction that is substantially parallel to the upper surface of the first substrate.

14. The semiconductor device according to claim 12 or claim 13, further comprising a third gate structure on the cell capacitor structure.

15. A semiconductor device comprising:
a first substrate comprising a first cell region and a first peripheral circuit region;
a first gate structure in the first cell region of the first substrate;
a bit line structure on the first cell region of the first substrate;
a cell capacitor structure on the bit line structure;
a decoupling capacitor structure on the first peripheral circuit region of the first substrate;
a second substrate on the cell capacitor structure and the decoupling capacitor structure, wherein the second substrate comprises a second cell region and a second peripheral circuit region that correspond to the first cell region of the first substrate and the first peripheral circuit region of the first substrate, respectively;
a second gate structure on the second cell region of the second substrate;
a third gate structure on the second peripheral circuit region of the second substrate; and
through vias that extend into the second substrate, wherein ones of the through vias are electrically connected to the cell capacitor structure and the decoupling capacitor structure.
